# EUROPÄISCHE PATENTSCHRIFT

(11) **EP 0 472 990 B1**
(45) Veröffentlichungstag und Bekanntmachung des Hinweises auf die Patenterteilung: **28.06.1995**
(21) Anmeldenummer: 91113464.1
(22) Anmeldetag: 12.08.1991
(51) Int. Cl.: B05D 1/18

(54) **Auf Trägern angebrachte ein oder mehrlagige Schichtelemente und ihre Herstellung**
Mono or multilayer deposits on a substrat and process for making them
Dépôt mono- ou multicouche sur un substrat et procédé de fabrication

(30) Priorität: 25.08.1990 DE 4026978
(43) Veröffentlichungstag der Anmeldung: 04.03.1992
(73) Patentinhaber: BAYER AG, 51368 Leverkusen (DE)
(72) Erfinder: Decher, Gero, Dr., W-6200 Wiesbaden-Biebrich (DE); Hong, Jong-Dal, W 6500 Mainz (DE)

(56) Entgegenhaltungen:
- US-A- 4 539 061
- MAKROMOLEKULARE CHEMIE, MACROMOLECULAR SYMPOSIA Bd. 46, Juni 1991, BASEL CHSeiten 321 - 327 , XP233444 G.DECHER ET AL. 'Buidup of ultrathin multilayerfilms by a self assembly process,1. Consecutive adsorbtion of anionic andcationic bipolar amphiphiles on charged surfaces'

## Beschreibung

Die Erfindung betrifft auf Trägern angebrachte Schichtelemente, die ein- oder mehrlagig sein können. Die einzelnen Schichten werden aus einer Lösung von für die Schichtbildung in Frage kommenden organischen Materialien zunächst auf einem modifizierten Träger und dann auf der jeweils vorangegangenen Schicht angebracht. Der Aufbau dieser Schichtelemente erfolgt somit durch sequentielle Physisorption (Salzbildung). Die Erfindung betrifft somit auch die Herstellung solcher Schichtelemente.

Beschichtete Träger finden in der industriellen Technik mannigfaltige Verwendung. Beispielsweise können die Reibungseigenschaften von Materialien durch entsprechende Behandlung ihrer Oberfläche einem gewünschten Zweck angepaßt werden. Weiterhin kann es sich um einen Schutzfilm für die darunterliegenden Träger handeln, um deren besondere Oberflächeneigenschaften zu konservieren. Insbesondere haben jedoch in letzter Zeit beschichtete Träger als Komponenten in Bauelementen für die optische Kommunikationstechnik sowie als elektronische und optoelektronische Informationsspeicher Einsatz gefunden.

Insbesondere für die elektronischen und optischen Einsatzzwecke ist es erforderlich, äußerst dünne, defektfreie mehrlagige Beschichtungen zu erzeugen, deren Lagen einen hohen Ordnungsgrad und eine einstellbare, weitgehend homogene Schichtdicke haben, wobei dieser hohe Ordnungsgrad auch im Bereich einer großen Anzahl von Beschichtungslagen erhalten bleiben soll.

Die aus geeigneten organischen Materialien hergestellten dünnen Schichten stellen demnach die Grundlage für auf Molekularebene geordnete, defektfreie Systeme dar, wie sie z.B. erforderlich sind für
- optische Anwendungen (gerichtete Strahlung geringer Dämpfung, z.B. Lichtwellenleiter mit nichtlinearoptischen Eigenschaften),
- elektrische Anwendungen (elektrische Leiter hoher Anisotropie, z.B. eindimensionale oder zweidimensionale Leiter auf dem Gebiet der Molekularelektronik),
- "Wirtsgitter" für den definierten Einbau bzw. eine spezifische Bindung von funktionellen Gruppen oder Molekülen.

Weitere Einsatzgebiete solcher auf Trägern angebrachter Schichtelemente sind die Modifizierung von Elektroden und ihr Einsatz in der Katalyse chemischer Reaktionen, sowie Sensoren, Biosensoren, Oberflächenvergütungen (z.B. Beschichtung kationischer Oberflächen, etwa Schlauchinnenseiten, mit Heparin zur Erhöhung der Biokompatibilität).

Die bisher am meisten untersuchte Methode zur Herstellung von ultradünnen Filmen und mehrlagigen Schichten ist die klassische Langmuir-Blodgett(LB)-Methode. Hierbei erfolgt der Schichtaufbau durch sequentielle Übertragung von Monoschichten von einer Wasseroberfläche auf ein festes Substrat. Diese Methode ist durch einen relativ hohen apparativen Aufwand, der dennoch die Beschichtung nur kleiner Träger erlaubt, gekennzeichnet. Das organische Material zum Aufbau der Schichten muß eine ausreichende Fähigkeit zum Spreiten auf der Wasseroberfläche aufweisen.

Weiterhin wurde versucht, Carboxylgruppen enthaltende Träger, wie sie beispielsweise durch Oxidation von Polyethylenträgern hergestellt werden können, zur Grundlage gleichmäßiger Beschichtung zu machen. Hierzu wurden z.B. langkettige Carbonsäuren mit Hilfe von Calciumionen aus einer Lösung auf den beschriebenen Träger gebracht. Die Calciumionen vermitteln eine ionische Bindung zwischen den Carboxylgruppen des Trägers und der aufgebrachten Carbonsäure. Da Dicarbonsäuren und Calciumionen aus einer Lösung heraus sofort zu einem unlöslichen und nicht mehr weiter verwendbaren Salzniederschlag führen würden, können nur Monocarbonsäuren eingesetzt werden. Wollte man auf diese erste Schicht weitere Schichten aufbringen, müßte zunächst der nicht funktionalisierte, von der Carboxylgruppe abgewandte Molekülteil der Carbonsäure funktionalisiert werden, um einen weiteren Aufbau zu ermöglichen. Noch weiterhin wurde versucht, durch alternierende Reaktion von 1,10-Decan-bisphosphat und seinem Zirkoniumsalz oder durch alternierende Reaktion von 1,10-Decan-bisphosphat und Zirkonylchlorid einen mehrlagigen Schichtaufbau zu erzeugen. Solche Versuche endeten nach etwa 8 Schichten, weil dann die Oberfläche zu starke Defekte für einen geordneten weiteren Schichtaufbau zeigte. Im Falle der Verwendung des Zirkonylchlorids kann als Quelle der Defektbildung der Wechsel vom anorganischen Kristallgitter zum damit kombinierten organischen Kristall angenommen werden.

Es ist weiter beobachtet worden, daß auf einer ionisch modifizierte Trägeroberfläche beim Versuch der Beschichtung mit α,ω-beidseitig mit Ionen versehenen organischen Molekülen, wobei die Ionen den entgegengesetzten Ladungssinn haben, dadurch Defekte auftraten, daß viele der beidseitig mit Ionen versehenen organischen Moleküle sich nicht senkrecht zur Trägeroberfläche anordnen und dadurch mit nur einem ionischen Ende dieses Moleküls eine Bindung mit dem Träger eingehen, sondern sich flächig, d.h. parallel zur Trägeroberfläche anordnen und mit den beiden ionischen Enden des Moleküls eine Bindung mit der ionischen Trägeroberfläche eingehen. Dadurch bleibt einerseits keine funktionelle Gruppe (in diesem Fall die 2. ionische Gruppe dieses organischen Moleküls) für den weiteren Aufbau von Schichten übrig und zum anderen bedeckt ein solches unerwünschterweise parallel zur Trägeroberfläche adsorbiertes organisches Molekül die zwischen den beiden entstehenden Bindungsstellen vorhandenen ionischen Gruppen des darunterliegenden Trägers und schließt diese bedeckten ionischen Gruppen von der Bildung geordneter Schichten aus.

Die Bildung von organischen Monoschichten ist schließlich durch Adsorption organischer Mercaptoverbindungen, beispielsweise auf Goldoberflächen möglich, (Self-Assembly-Technik).

In US-A-4 539 061 ist die Herstellung von Vielschichtfilmen beschrieben, die durch schrittweise Anbringung einzelner Monoschichten auf einer festen polaren Unterlage erfolgt. Jede neue Schicht wird durch Absorption von Molekülen aus einer flüssigen Phase heraus gebildet; die Moleküle haben jeweils ein polares und ein unpolares Ende. Zur Verankerung der nächsten Schicht wird die vorausgegangene Schicht durch chemische Reaktion in definierter Weise vorbereitet; die Verankerungsgruppen können unter anderem auch ionischen Charakter haben.

Es bestand daher weiterhin das Bedürfnis nach auf Trägern angebrachten Schichtelementen, die einen hohen Ordnungsgrad ohne die beschriebenen Defekte aufweisen.

Solche auf Trägern angebrachten Schichtelemente sollten weiterhin eine größere mechanische und thermische Stabilität sowie eine größere Lösungsmittelbeständigkeit als etwa LB-Schichten aufweisen. Zusätzlich sollten neue auf Trägern angebrachte Schichtelemente in Form größerer Flächen herstellbar sein.

Die genannten Nachteile werden durch die erfindungsgemäßen auf Trägern angebrachten ein- oder mehrlagigen Schichtelemente überwunden. Die erfindungsgemäßen Schichtelemente bilden ein hochgeordnetes Organisat, welches durch Physisorption unter Salzbildung erhalten wird und bei dem jeweils eine gleichförmig geladene Oberfläche vorhanden ist, die in der Folgeschicht mit organischen Molekülen belegt wird, die den entgegengesetzten Ladungssinn der vorangegangenen Schicht aufweisen.

Die Erfindung betrifft auf einem Träger angebrachte Schichtelemente, bestehend aus
a) einem modifizierten Träger mit ebenmäßiger Oberfläche, wobei die Modifizierung die flächenweite Anbringung von Ionen oder ionisierbaren Verbindungen gleichsinniger Ladung bedeutet, und
b) einer oder mehrerer Schichten aus organischen Materialien, die in jeder Schicht gleichsinnig geladene Ionen enthalten, wobei die Ionen der ersten Schicht den entgegengesetzten Ladungssinn zur Modifizierung des Trägers aufweisen und bei mehreren Schichten jede weitere wiederum den entgegengesetzten Ladungssinn der vorangegangenen aufweist und wobei die organischen Materialien monomere Stoffe mit zwei ionischen oder ionisierbaren funktionellen Gruppen gleichsinniger Ladung oder Polymere mit einer Vielzahl ionischer oder ionisierbarer funktioneller Gruppen gleichsinniger Ladung (Polyelektrolyte) sind.

Die Erfindung betrifft weiterhin ein Verfahren zur Herstellung von auf Trägern angebrachten Schichtelementen, das dadurch gekennzeichnet ist, daß man
i) einen Träger mit ebenmäßiger Oberfläche so modifiziert, daß er flächenweit Ionen oder ionisierbare Verbindungen gleichsinniger Ladung trägt, und
ii) eine oder mehrere Schichten aus organischen Materialien, die in jeder Schicht gleichsinnig geladene Ionen enthalten, aus einer Lösung solcher organischer Materialien auf den modifizierten Träger aufbringt, wobei das organische Material für die erste Schicht Ionen mit entgegengesetztem Ladungssinn zum Ladungssinn der Ionen der Modifizierung des Trägers aufweist und im Falle von mehreren Schichten abwechselnd weitere Schichten mit Ionen mit dem jeweils entgegengesetzten Ladungssinn zur vorhergehenden in gleicher Weise wie die erste Schicht aufträgt und wobei die organischen Materialien monomere Stoffe mit zwei ionischen oder ionisierbaren funktionellen Gruppen gleichsinniger Ladung oder Polymere mit einer Vielzahl ionischer oder ionisierbarer funktioneller Gruppen gleichsinniger Ladung (Polyelektrolyte) sind.

Multischichtsysteme der beschriebenen Art bestehen aus mindestens 2 Materialien mit entgegengesetzt geladenen ionischen Gruppen. Der einfachste Schichtaufbau entspricht also dem Typ ABABAB... . Die Funktionalität der Schichten kann aber durch die Verwendung von mehr als 2 Materialien gezielt erhöht werden, z.B. ABCBABABCB ... oder ABCDCBADCBAC..., wobei A und C sowie B und D die gleiche Ladung tragen. Der Schichtaufbau ergibt sich konsequent aus der Auswahl des Tauchbades zum jeweiligen Auftragen der einzelnen Schichten.

Das erfindungsgemäße Verfahren erlaubt die großflächige Herstellung hochgeordneter Multischichten Schichtelemente auf Trägern.

Als Träger für die erfindungsgemäßen Schichtelemente kommen solche mit ebenmäßiger, lösungsmittelzugänglicher Oberfläche in Frage, beispielsweise ebene, zylinderförmige, kegelförmige, kugelförmige oder andere gleichmäßig geformte Träger, also auch Innenflächen von Flaschen, Schläuchen usw.; Träger mit ebener Oberfläche sind bevorzugt. Die Träger können für verschiedene optische oder elektrische Anwendungsgebiete transparent, undurchlässig oder reflektierend sowie elektrisch leitend, halbleitend oder isolierend sein. Die chemische Natur dieser Träger kann anorganisch oder organisch sein. Anorganische Trägermaterialien sind beispielsweise Metalle, Halbleitermaterialien, Gläser oder keramische Materialien, wie Gold, Platin, Nickel, Palladium, Aluminium, Chrom, Stahl und andere Metalle Germanium, Galiumarsenid, Silicium und andere Halbleitermaterialien, Gläser der verschiedensten chemischen Zusammensetzung, Quarzglas, weitere Gläser, sowie Porzellan und weitere Mischoxide, die als keramische Materialien verstanden werden. Weitere anorganische Stoffe, die sich als Träger eignen sind etwa Graphit, Zinkselenid, Glimmer, Siliciumdioxid, Lithiumniobat und weitere Träger, gegebenenfalls als anorganische Einkristalle, wie sie dem Fachmann aus der LB-Technik bekannt sind.

Organische Materialien für die Träger in den erfindungsgemäßen Schichtelementen sind wegen der Dimensionsstabilität und der Lösungsmittelbeständigkeit vorwiegend polymere Werkstoffe, Genannt seien beispielsweise: Polyester, wie Polyethylenterephthalat, Polybutylenterephthalat und andere, Polyvinylchlorid, Polyvinylidenfluorid, Polytetrafluorethylen, Polycarbonat, Polyamid, Poly(methyl)acrylate, Polystyrol, Polyethylen oder Ethylen-vinylacetat-Copolymer. Auch solche organischen Träger sind dem Fachmann aus der LB-Technik bekannt.

Die chemische Natur des Trägermaterials spielt eine untergeordnete Rolle, so daß die obigen Aufzählungen nur beispielhaft und nicht erschöpfend sind.

Die erfindungsgemäß einzusetzenden Träger haben geladene oder ionisierbare Oberflächen oder ihre Oberflächen werden so modifiziert, daß sie flächenweit mit Ionen oder ionisierbaren Verbindungen gleichsinniger Ladung bedeckt sind. Diese flächenweite Anbringung kann eine erste monomolekulare Schicht, die fest mit dem Träger verknüpft ist, bedeuten. Die flächenweite Anbringung von Ionen oder ionisierbaren Verbindungen kann jedoch auch durch eine chemische Reaktion am Träger selbst bewirkt werden, bei der an der Oberfläche im Ausmaß einer monomolekularen Schicht eine dichte Belegung mit gleichsinnig geladenen Ionen oder ionisierbaren Gruppen bewirkt wird. Eine solche Modifizierung ist dem Fachmann, der auf dem Gebiet mehrlagiger dünner Schichten tätig ist, bekannt. Beispiele hierfür sind Self-Assembly-Monoschichten, z.B. aus einem α,ω-Dithiol, Cysteamin, Aminogruppen enthaltenden Thiolen und anderen Thiolen, die eine weitere ionische oder ionisierbare Gruppe enthalten, auf Metallen, wie Gold, Silber, Cadmium und anderen. Hierbei verbindet sich die Thiolgruppe fest mit der metallischen Oberfläche und die zweite Thiolgruppe, eine Carboxylgruppe, eine Aminogruppe oder eine andere ionische oder ionisierbare Gruppe bildet die ionische Modifizierung des einzusetzenden metallischen Trägers. Ein weiteres wichtiges Beispiel ist eine Silanisierung der Oberfläche mit Alkoxygruppen enthaltenden Silanen, die zusätzlich eine weitere ionische oder ionisierbare Gruppe enthalten. Diese Silanisierung ist in der dem Fachmann bekannten Weise bei allen Silicium enthaltenden Trägern möglich. Die ionische oder ionisierbare Gruppe kann beispielsweise eine Sulfonsäuregruppe oder eine ionisierbare Aminogruppe sein. Ein noch weiteres Beispiel betrifft die chemische Modifizierung polymerer organischer Träger (polymeranaloge Umsetzung). So kann beispielsweise Polyethylen durch Oxidationsmittel, wie Chromsäure, oberflächlich mit Carboxylgruppen ausgerüstet werden. (Meth)acrylate oder (Meth)acrylamide können durch Verseifung ebenfalls oberflächlich mit Carboxylgruppen ausgerüstet werden. Auch die oberflächliche Sulfonierung von Polystyrolharzen führt zu einer erfindungsgemäß nutzbaren Modifizierung. Die zuletztgenannten modifizierten Polymere können auch als Flachionenaustauscher bezeichnet werden. Es ist dem Fachmann weiterhin geläufig, daß anstelle anionischer Gruppen (Carboxylgruppen, Sulfogruppen) auch kationische Gruppen, wie Aminogruppen durch Chlormethylierung und nachfolgende Einführung einer Aminogruppe erhalten werden können. Solche Umsetzungen sind als polymer-analoge Reaktionen bekannt.

Weiter ist frisch gespaltener Glimmer zu nennen, auf den direkt kationische Verbindungen adsorbiert werden können. Ferner können auf Glas oder Quarz nach kurzem Eintauchen in Natronlauge ebenfalls kationische Verbindungen, wie Polyethylenimin adsorbiert werden.

In allen genannten und in weiteren denkbaren Fällen ist es nicht kritisch, welcher Art die Ionen oder ionisierbaren Gruppen auf der Oberfläche des Trägers sind, sondern die dichte, flächenweite Belegung mit solchen Gruppen ist ausschlaggebend.

Wichtig ist fernerhin, daß stets gleichsinnig geladene Ionen oder ionisierbare Gruppen die Modifizierung des Trägers darstellen.

Die organischen Materialien zur Ausbildung der einzelnen Schichten auf dem modifizierten Träger stellen entweder monomere Stoffe mit zwei ionischen oder ionisierbaren funktionellen Gruppen gleichsinniger Ladung (sogenannte Bolaamphiphile) oder Polymere mit einer Vielzahl ionischer oder ionisierbarer funktioneller Gruppen gleichsinniger Ladung (sogenannte Polyelektrolyte oder Polyionene) dar. Diese organischen Materialien tragen stets funktionelle Gruppen gleichsinniger Ladung (also entweder Kationen oder zu Kationen ionisierbare Gruppen bzw. Anionen oder zu Anionen ionisierbare Gruppen). Hierbei ist es durchaus denkbar, daß verschiedene Kationen bzw. verschiedene Anionen oder zu solchen ionisierbare Gruppen im Molekül vertreten sein können. Aus Gründen der Zugänglichkeit und leichteren Herstellbarkeit ist es jedoch bevorzugt, daß in den monomeren Stoffen die beiden funktionellen Gruppen identisch sind und daß auch in den Polymeren die Vielzahl der funktionellen Gruppen identisch ist.

Die niedermolekularen Bolaamphiphile enthalten im Zentrum ein Hartsegment, wie es auch in stäbchenförmigen (calamitischen) Flüssigkristallen als mesogene Gruppe vorhanden ist. Solche Gruppen sind etwa Biphenyl, Terphenyl, Stilben, Tolan, bis-Arylester, Azobenzole, bzw. solche Verbindungen, in denen der aromatische Ring hydriert ist. Diese und andere mesogene Gruppen sind dem Fachmann bekannt. In der unten angegebenen allgemeinen chemischen Formel (I) wird die angesprochene Gruppe mit -X- bezeichnet und mit Beispielen näher erläutert.

In bevorzugter Weise werden in den Schichtelementen für den Fall der Verwendung monomerer Stoffe solche der Formel

Ion-Z¹-(-Y¹-Z²-)ₘ-X-Z³-Y²-Z⁴-Ion (I)

eingesetzt, in der
- X: -C≡C-C≡C-, 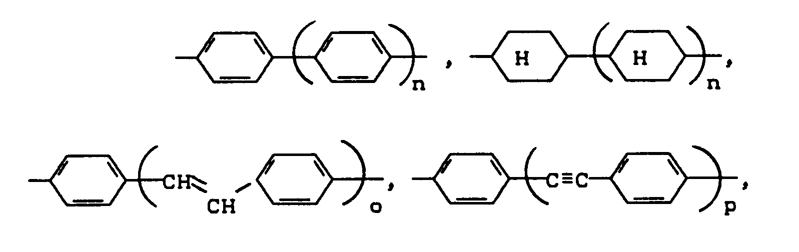 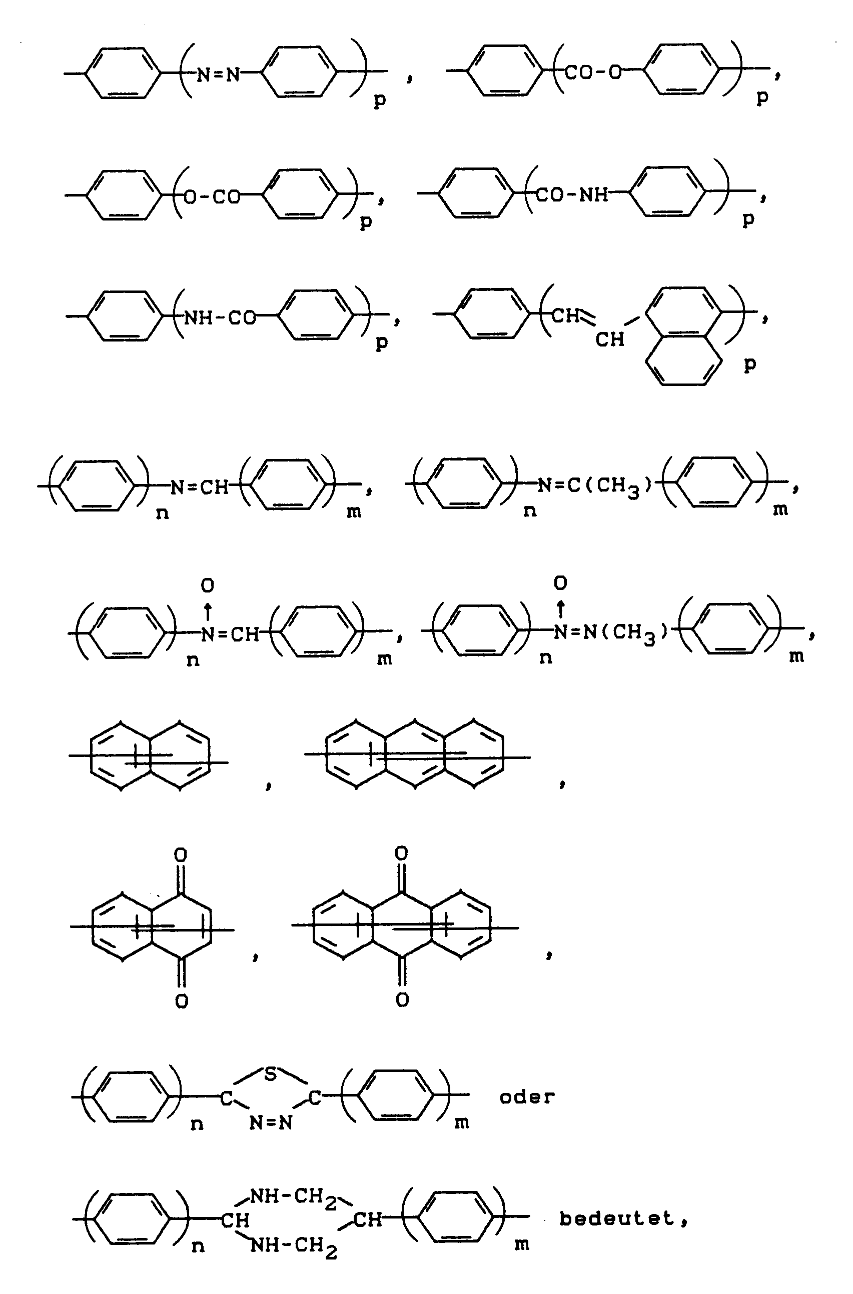 wobei die aromatischen Kerne in diesen Gruppen ein- bis dreifach durch Methyl, Fluor oder Chlor substituiert oder zum Cycloalkan hydriert sein können,
- Y¹ und Y²: unabhängig voneinander für -(-CH₂-)_{q}-, -(-Si(CH₃)₂-O-)_{q}-, -(-CH=CH-)_{q}- oder -(C≡C-)_{q}- stehen,
wobei in diesen Gruppen die Wasserstoffatome teilweise oder ganz durch Methyl, Fluor oder Chlor substituiert sein können,
- Z¹, Z², Z³ und Z⁴: unabhängig voneinander eine Einfachbindung, -O-, -S-, -CO-, -SO-, -SO₂-, -CO-O-, -O-CO-, =N-CO, -CO-N=, -NH- oder -N(C₁-C₄-Alkyl)- darstellen,
- Ion: für ein Kation, ein Anion oder eine zum Kation oder Anion ionisierbare Gruppe steht,
- m: 0 oder 1, bevorzugt 1,
- n: ganzzahlige Werte von 0 bis 7,
- o: ganzzahlige Werte von 1 bis 3,
- p: den Wert 1 oder 2 und
- q: ganzzahlige Werte von 1 bis 20 darstellen.

In bevorzugter Weise bedeutet X eine der Gruppen

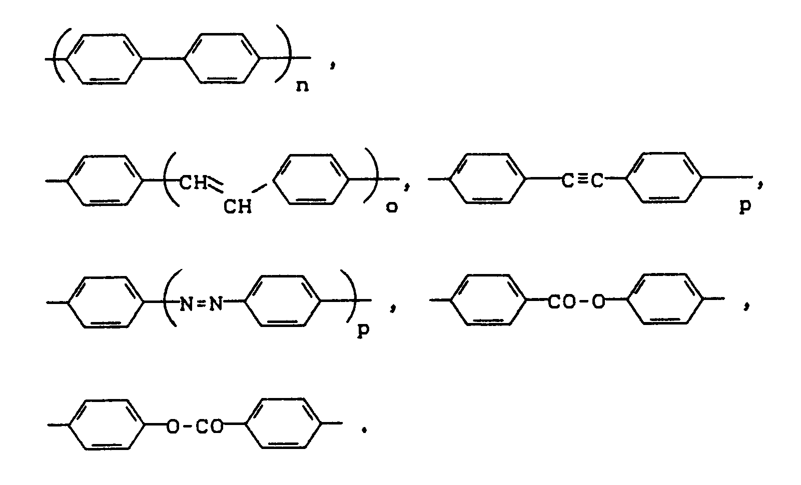

Der Index n nimmt in bevorzugter Weise ganzzahlige Werte von 0 bis 3 an. Der Index o nimmt in bevorzugter Weise den Wert 1 oder 2 an. Der Index p nimmt in bevorzugter Weise den Wert 1 an.

Y¹ und Y² bedeuten in bevorzugter Weise -(CH₂)_{q}-, worin die Wasserstoffatome teilweise oder vollständig durch Methyl, Fluor oder Chlor ersetzt sein können. In besonders bevorzugter Weise nehmen Y¹ und Y² unabhängig voneinander die Bedeutung -(CH₂)_{q}- an, worin die Wasserstoffe nicht substituiert sind. Der Index q nimmt in bevorzugter Weise ganzzahlige Werte von 4 bis 14, in besonders bevorzugter Weise von 6 bis 12 an. Z¹ bis Z⁴ nehmen in bevorzugter Weise die Bedeutung -O-, -CH₂-, -CO-NH-, Einfachbindung oder -CO-O- an.

Als über Z¹ und Z⁴ gebundene Kationen seien solche der Formeln 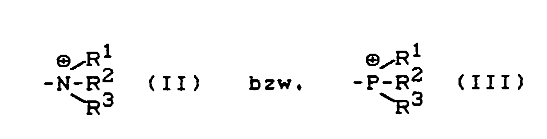
oder ionisierbare, wie 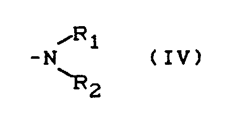
genannt, in der
- R¹, R² und R³: unabhängig voneinander Wasserstoff, geradkettiges oder verzweigtes C₁-C₄-Alkyl oder C₅-C₆-Cycloalkyl bedeuten, wobei R³ weiterhin Phenyl oder Benzyl bedeuten kann und
wobei weiterhin in (II) bzw. (IV) zwei der Reste R¹ bis R³ gemeinsam mit dem N-Atom, das sie substituieren einen Pyridinring, Morpholinring, Piperidinring oder Pyrimidinring bilden können.

In bevorzugter Weise bedeuten die Reste R¹ bis R³ Wasserstoff oder geradkettiges oder verzweigtes C₁-C₄-Alkyl, wobei R³ auch Benzyl bedeuten kann und wobei in (II) zwei der Reste R¹ bis R³ einen der obengenannten heterocyclischen Ringe bilden kann.

Solche Kationen sind zum Ladungsausgleich mit Anionen, wie Chlorid, Bromid, Iodid, Fluorid, Tetrafluorborat, Perchlorat, Nitrat, Sulfat, Hydrogensulfat, Tosylat, Acetat, Methylsulfat, Trifluormethylsulfat, höheres Alkylsulfonat oder Benzolsulfonat kombiniert. Bevorzugte Anionen zum Ladungsausgleich sind die einwertigen, unter ihnen die einfachen, wie die Halogenide, Perchlorat oder Acetat.

Für den Fall, daß Ion ein Anion bedeutet, ist dies beispielsweise Carboxylat, Sulfonat, Phosphonat oder Alkylsulfat. Zum Ladungsausgleich sind solche Anionen mit den Kationen der Alkalimetalle, der Erdalkalimetalle, dem Ammoniumion oder dem ganz oder teilweise substituierten Ammoniumion kombiniert; bevorzugte Kationen sind die einwertigen, vor allem die der Alkalimetalle und das nicht substituierte Ammoniumion und das Tetramethylammoniumion.

Eine zu einem Anion ionisierbare funktionelle Gruppe kann beispielsweise eine nicht vollständig dissoziierte Carboxylgruppe sein.

Eine zu einem Kation ionisierbare funktionelle Gruppe ist z.B. eine Aminogruppe, die erst durch den Säuregrad des Lösungsmittels bzw. durch eine saure Gruppe auf dem ionischen Träger protoniert wird.

Grundsätzlich können Gemische verschiedener Stoffe der Formel (I) eingesetzt werden, sofern sie die Forderung nach einem Gehalt an gleichsinnig geladenen Ionen erfüllen. Zur Erzielung gleichmäßig dicker Schichten ist es jedoch bevorzugt, pro Schicht jeweils nur einen Stoff der Formel (I) einzusetzen.

Polymere mit einer Vielzahl an ionischen oder ionisierbaren funktionellen Gruppen werden auch als Polyelektrolyte bezeichnet. Anionische bzw. kationische oder ionisierbare Gruppen in solchen Polymeren sind beispielsweise:

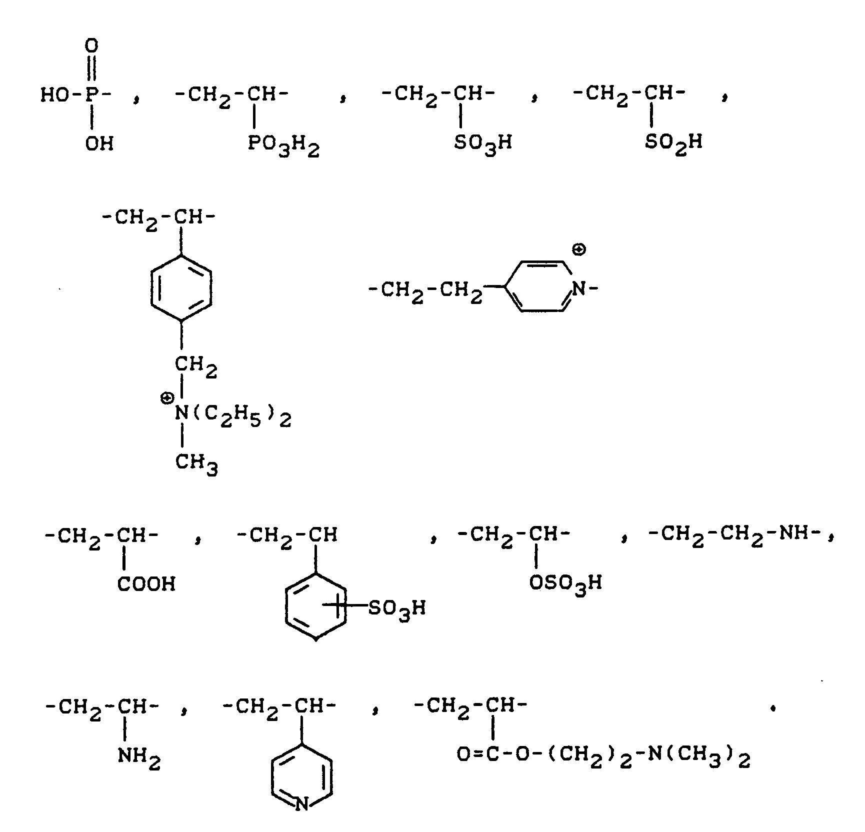

Als Polyelektrolyte seien beispielsweise aufgeführt: Polyacrylsäure, Polymethacrylsäure, Polyethylensulfonsäure, Polyvinylsulfonsäure, Polystyrolsulfonsäure, Polyvinylphenylschwefelsäure (Phenolester), Maleinsäurealken-Copolymer, Maleinsäure-vinylalkylether-Copolymer, Polyglutaminsäure, Polylysin, sowie die entsprechenden Copolymere mit neutralen Aminosäuren, Polyvinylamin, Polyethylenimin, Polyvinyl-4-alkylpyridiniumsalz, Poly(methylen)-N,N-dimethylpiperidiniumsalz, Poly(vinylbenzyltrimethylammonium)-salz.

Wichtige und gut verarbeitbare Polyelektrolyte sind in besonderer Weise:

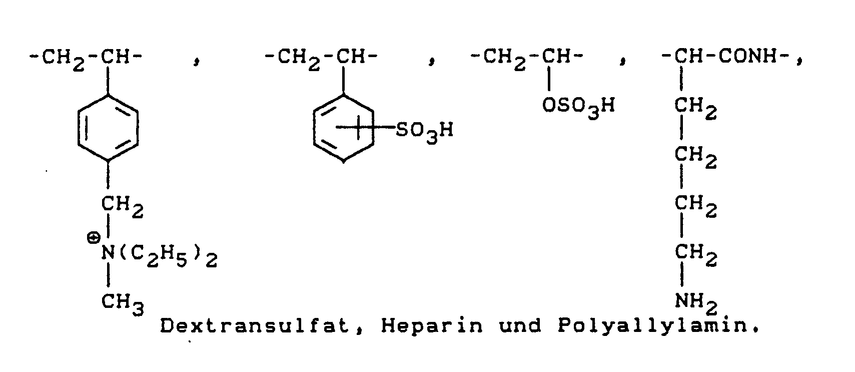

Die Kette des polymeren organischen Materials für die Schichtelemente kann demzufolge ein Polyolefin, ein Acrylpolymer, ein Polyvinylacetat, ein Polyester, ein Polyamid, eine Poly- oder Copolyaminosäure, wie Polylysin oder Polyglutaminsäure, ein ionisches Polysaccharid oder ein anderes, dem Fachmann bekanntes Polymer sein. Das Polymer kann die Ionen oder die ionisierbaren funktionellen Gruppen in der Monomereinheit tragen und damit wasserlöslich sein, es kann sich aber auch zunächst um ein hydrophobes und damit nicht wasserlösliches Polymer handeln, bei dem Ionen oder ionisierbare Gruppen durch polymeranaloge Reaktionen eingebaut werden.

Sowohl in monomere organische Materialien als auch in polymere organische Materialien können Farbstoffe und für die endgültige Verwendung der erfindungsgemäßen auf Trägern angebrachten Schichtelemente wichtige Wirkstoffe durch kovalente Bindung angebracht oder integriert werden. Ein Beispiel ist jeweils ein Stoff aus dem Paar Antikörper/Antigen für Zwecke der Sensorik, etwa aus dem Paar Biotin/Streptavidin.

Für den Fall, daß man bei der Verwendung monomerer organischer Materialien von einer Mischung mit gleicher Moleküllänge aber unterschiedlichem Molekülaufbau im Rahmen der Formel (I) ausgeht, kann innerhalb einer hiermit aufgebauten Schicht eine laterale Kristallisation verhindert werden, wodurch diese Schicht zweidimensional amorph und damit optisch homogener wird. Durch die unterschiedliche Einstellung eines solchen Gemisches monomerer organischer Materialien kann für verschiedene optische Anforderungen ein maßgeschneidertes Schichtelement hergestellt werden. Beim Einsatz polymerer organischer Materialien (Polyelektrolyte) ist der amorphe Charakter einer durch sie aufgebauten Schicht im allgemeinen auch ohne Einsatz eines Gemisches mehrerer Polyelektrolyte gegeben.

Während bei monomeren Bolaamphiphilen immer eine vollständige Monoschicht konstanter Dicke aufgebracht wird, kann bei den Polyelektrolyten zusätzlich die Dicke der aufgebrachten Monoschicht durch Variation der Parameter Polymermolgewicht, Konzentration und Adsorptionszeit eingestellt werden. So ergeben kleine Molgewichte und/oder kleine Konzentrationen kleine Schichtdicken, während große Molgewichte und/oder hohe Konzentrationen große Schichtdicken ergeben.

Es ist weiterhin eine besondere Variante der Erfindung, daß auf einem empfindlichen modifizierten Träger zunächst nur eine Schicht aus monomeren organischen Materialien (Bolaamphiphile) oder einem polymeren organischen Material (Polyelektrolyt) aufgebracht werden, um so die durch Modifizierung empfindlich gewordene Trägerschicht zu versiegeln und damit zu schützen. Auf dieser Stufe kann sodann die weitere Schichtenbildung zunächst abgebrochen werden, um erst nach einiger Zeit (etwaige Zwischenlagerung) wieder aufgenommen zu werden. Ein solcher einlagig beschichteter modifizierter Träger stellt somit eine lagerstabile Vorstufe für mehrlagige erfindungsgemäße Schichtelemente dar.

Zur Herstellung der erfindungsgemäßen auf Trägern angebrachten Schichtelemente können die einzelnen Schichten auf den modifizierten Träger aus ihren Lösungen in einem geeigneten Lösungsmittel aufgetragen werden. Hierbei wird bei jedem Auftrag eine Lösung mit organischem Material mit dem jeweils entgegengesetzten Ladungssinn seiner funktionellen Gruppen verwendet. Zwischen den einzelnen Aufträgen werden ungebundene oder nur locker adsorbierte Restmengen an organischem Material aus dem jeweils vorangegangenen Auftrag durch Spülen entfernt.

Als Lösungsmittel sind geeignet: Wasser, wäßrige Lösungen von Salzen (z.B. NaCl, MnCl₂, (NH₄)₂SO₄) und mit Wasser mischbare, nicht ionische Lösungsmittel, wie C₁-C₄-Alkanole, C₃-C₆-Ketone einschließlich des Cyclohexanons, Tetrahydrofuran, Dioxan, Dimethylsulfoxid, Ethylenglykol, Propylenglykol sowie Oligomere von Ethylen- und Propylenglykol sowie deren Ether und offenkettige und cyclische Amide, wie Dimethylformamid, Dimethylacetamid, N-Methylpyrrolidon und andere. Nur in speziellen Fällen werden polare, nicht mit Wasser mischbare Lösungsmittel, wie Chloroform oder Methylenchlorid in Frage kommen, die einen Anteil der obengenannten organischen Lösungsmittel enthalten können, soweit eine Mischbarkeit mit diesen gegeben ist. Bevorzugt werden Wasser oder Lösungsmittelgemische eingesetzt, deren einer Teil Wasser ist. Sofern es die Löslichkeit der monomeren oder polymeren organischen Materialien (Bolaamphiphile bzw. Polyelektrolyte) zulassen, wird wegen der Verfahrensvereinfachung nur mit Wasser als dem Lösungsmittel gearbeitet.

Es wurde vielfach beobachtet, daß monomere organische Materialien (Bolaamphiphile) sich in Wasser als Lösungsmittel parallel zueinander anordnen und Micellen bilden, wodurch ein geordneter regelmäßiger Aufbau auf dem Träger erleichtert wird. Weiterhin können die Bolaamphiphile auch in einem anderen Winkel als 90° zur Trägeroberfläche oder zur zuletzt angebrachten Schicht aufziehen, wenn dies nur regelmäßig durch die gesamte Schicht vollzogen wird.

Beim Auftrag von Polyelektrolyten binden diese flächig und schließen daher einen Verlust an bindungsfähigen Punkten der jeweils darunterliegenden Schicht aus. Dies wird noch dadurch begünstigt, daß keine diskreten kovalenten Bindungen auftreten, sondern durch die elektrostatischen Kräfte eine räumlich fixierte Zuordnung der Ionen verschiedener Schichten nicht erforderlich ist.

Das erfindungsgemäße Verfahren zur Herstellung der neuen auf Trägern angebrachten Schichtelemente kann leicht in die kontinuierliche Arbeitsweise umgesetzt werden, indem man den zu beschichtenden modifizierten Träger nacheinander durch verschiedene Bäder mit den abwechselnd aufzutragenden organischen Materialien und dazwischengeschaltete Bäder mit Waschflüssigkeiten führt. Dies ist eine erhebliche Arbeitserleichterung, verglichen mit der LB-Technik, Sie wird erleichtert dadurch, daß die Anforderungen an die Sauberkeit zwischen dem Auftrag zweier Schichten nicht so hoch sind wie bei der LB-Technik.

Zum Aufbau der erfindungsgemäßen auf Trägern angebrachten Schichtelemente ist es möglich, in allen Schichten von monomeren organischen Materialien mit von Schicht zu Schicht wechselndem Ladungssinn auszugehen.

Desgleichen ist es möglich nur von Polyelektrolyten mit jeweils von Schicht zu Schicht wechselndem Ladungssinn auszugehen. Es ist jedoch gleichermaßen möglich, abwechselnd Bolaamphiphile und Polyelektrolyte, wiederum mit jeweils abwechselndem Ladungssinn einzusetzen.

Gleichermaßen geeignet sind Polyelektrolyte, die sowohl kationische als auch anionische Gruppen tragen und die dann ein ähnliches Absorptionsverhalten zeigen, wenn eine der beiden Gruppen im Überschuß vorliegt.

Es ist gelungen, bis zu 110 Schichten auf einem modifizierten Träger im erfindungsgemäßen Sinn anzubringen. Die erfindungsgemäßen Schichtelemente wurden durch folgende Meßmethoden charakterisiert:
Mittels UV/Vis-Spektroskopie wurden die Schichtsysteme auf Quarzträgern in Transmission in Abhängigkeit von der Schichtdicke untersucht. Es zeigten sich weder bei den Bolaamphiphilen (Banden bei 284 nm und 263 nm) noch bei den Polyelektrolyten (Bande bei 225 nm) Verschiebungen gegenüber den Lösungsspektren. Ein gleichförmiges Aufwachsen der Schichten bis zu einer Schichtzahl von 38 Lagen wurde durch eine konstante Zunahme der optischen Absorption nachgewiesen. Da die Absorption bei noch dickeren Schichten größer als 1,5 wird und somit außerhalb des linearen Bereichs kommt, ist die Methode für dickere Schichten aus prinzipiellen Gründen nicht mehr anwendbar.

Mittels Ellipsometrie wurde bei einer Wellenlänge von 633 nm nachgewiesen, daß bis zu einer Schichtdicke von 5 Lagen, unter der Annahme eines konstanten Brechungsindex, eine konstante Zunahme der Schichtdicke mit jeder Lage erfolgt. An einer Probe mit 6 Schichten Bolaamphiphil wurde an 5 verschiedenen Meßpunkten auf einem 2 cm² großen Träger eine Schichtdicke von 185 ± 1,2 Å bei einem Brechungsindex von n = 1,55 ermittelt.

Mittels Röntgenkleinwinkelstreuung wurden mehrere Proben untersucht, es wurde jedoch in keinem Fall ein Bragg-Reflex beobachtet. Dies deutet auf eine schlechte kristallographische Korrelation der einzelnen Lagen trotz der guten konstanten Schichtdicke der Gesamtschicht (siehe Ellipsometrie) hin.

Die gute Homogenität der Schichten wurde auch lichtmikroskopisch überprüft. Dabei zeigt sich eine Abhängigkeit der Schichtqualität von der Substratqualität. Effekte vom Rand des Trägers wirken sich bis etwa 2 mm auf die Schicht aus.

Lichtmikroskopisch konnte weder mit Normarski-Interferenzkontrast noch mit gekreuzten Polarisatoren eine laterale Struktur aufgelöst werden. Bei Auflichtmikroskopie auf reflektierenden Trägern (Si-Wafer) wurden über die gesamte beschichtete Fläche mit Ausnahme des Randes einheitliche Interferenzfarben beobachtet.

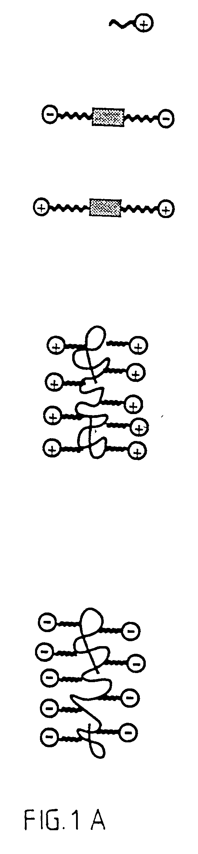

Die folgenden Ausführungsbeispiele erläutern das erfindungsgemäße Verfahren, ohne es auf diese einzuschränken. Eine Reihe von Ausführungsbeispielen werden durch die anhängenden Figuren (Fig. 1A, 1B und 2-12) zusätzlich illustriert.

Fig. 1A, 1B und 2-8 zeigen beispielhaft die Modifizierung eines Trägers (etwa Si oder Glas) und Möglichkeiten zum Aufbau von Multischichten. Die Zeichen [1] und [2] zeigen die jeweils hintereinander durchzuführenden Arbeitsschritte an. Fig. 1A enthält fünf Symbole, die in den folgenden Figuren erscheinen (von oben nach unten): das Kation C₂H₅O-Si(CH₃)₂-(CH₂)₃-N^{⊕}H₃; das Di-anion von Verbindung (5) aus Beispiel 5; das Di-kation von Verbindung (7) aus Beispiel 7; das Polymer mit einer Vielzahl von Kationen und der Formel 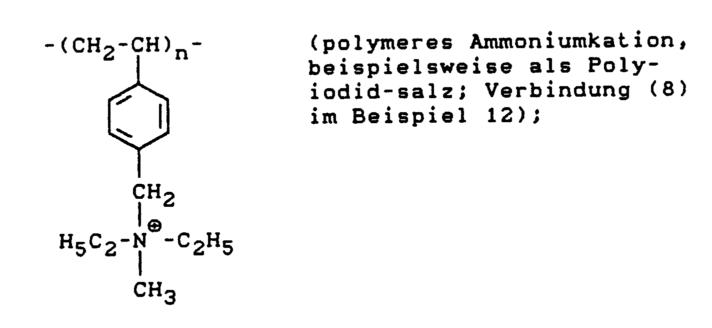
das Polymer mit einer Vielzahl von Anionen und der Formel

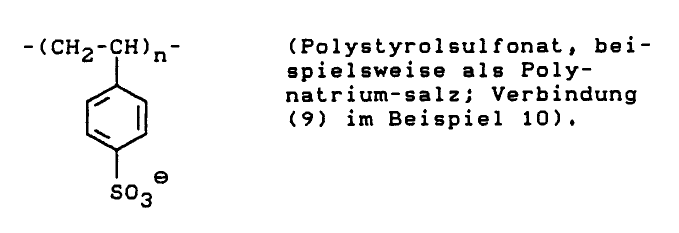

Fig. 1B zeigt beispielhaft die Modifizierung eines Trägers und Möglichkeiten zum Aufbau von Multischichten (Beispiel 8 und 9).
Fig. 2 illustriert Beispiel 10.
Fig. 3 und 6 illustrieren Beispiel 11.
Fig. 4 und 7 illustrieren Beispiel 12.
Fig. 5 und 8 illustrieren Beispiel 13.
Fig. 9 zeigt Formeln und Symbole für Poly-l-lysin mit MW 75000 (oben) und für biotinyliertes Poly-l-lysin (unten); vgl. Beispiel 14.
Fig. 10 zeigt im oberen Bild einen beschichteten Träger mit einer Deckschicht aus Poly-l-lysin (vgl. Beispiel 15); im unteren Bild ist eine Deckschicht aus biotinyliertem Poly-l-lysin angebracht (vgl. Beispiel 16).
Fig. 11 stellt eine biospezifische Erkennungsreaktion einer biotinylierten Trägeroberfläche (unteres Bild) im Vergleich zu einer nicht biotinylierten Trägeroberfläche (oberes Bild, keine Erkennung) mittels fluoreszenzmarkiertem Streptavidin dar (FITC = Fluoreszein-isothiocyanat).
Fig. 12 zeigt das Fluoreszenzspektrum der beiden Trägeroberflächen von Fig. 11, oberes und unteres Bild.

### Beispiele

Die Umsetzungen der Beispiele 1 bis 7 können formelmäßig wie folgt dargestellt werden:

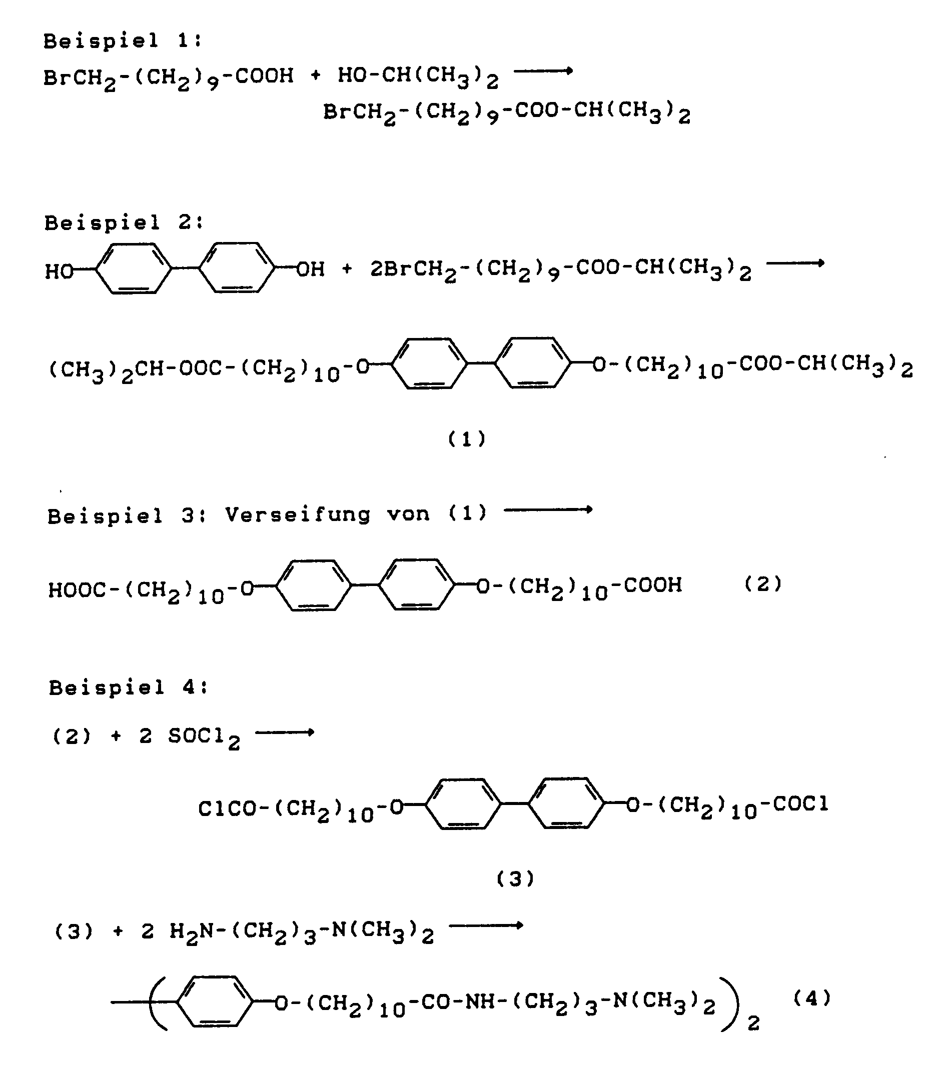

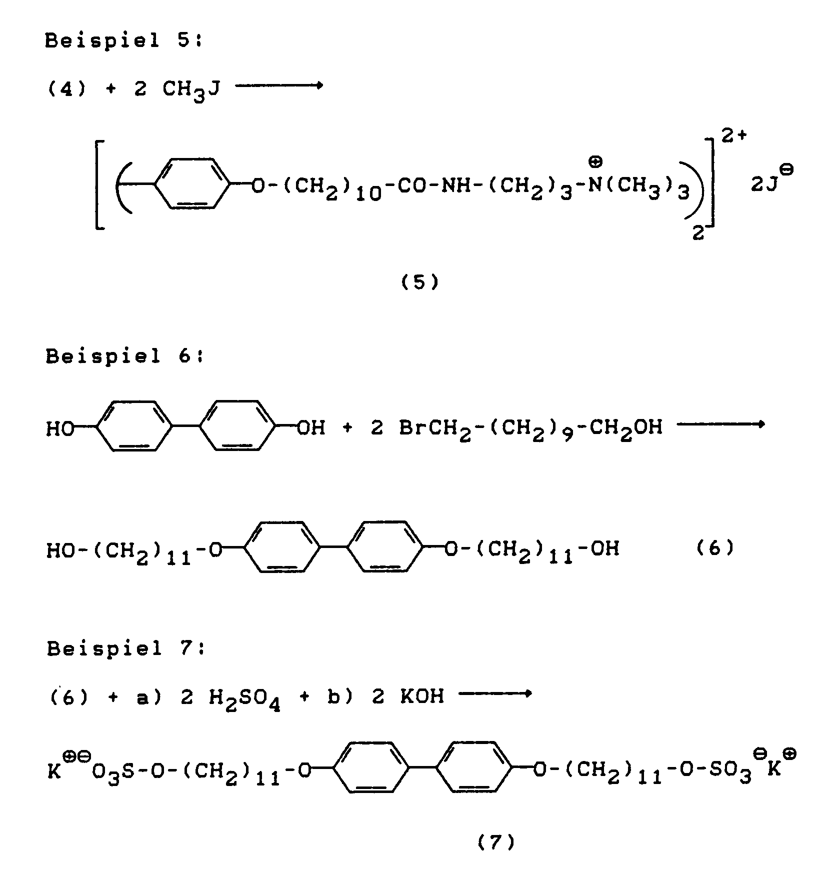

### Beispiel 1 Herstellung von 11-Brom-Undecansäureisopropylester.

35,6 g (0,13 mol) 11-Bromundecansäure wurden mit 40,3 g (0,67 mol) Isopropanol, 3,8 g (0,022 mol) p-Toluolsulfonsäure und 100 ml CHCl₃ versetzt und am Wasserabscheider unter Rückfluß erhitzt, bis sich kein Wasser mehr abschied. Nach Beendigung der Reaktion ließ man abkühlen und wusch mit Wasser, wäßriger Natriumhydrogencarbonatlösung, nochmals Wasser und destillierte anschließend das Lösungsmittel ab.

Aus dem gelben öligen Rückstand erhielt man durch Destillation 37,8 g (92 % der theoretischen Ausbeute) einer farblosen, klaren, etwas viskosen Substanz.
Identifizierung: IR- und NMR-Spektrum

### Beispiel 2 Herstellung von Verbindung (1) des obigen Formelschemas

10,4 g (0,06 mol) 4,4'-Dihydroxybiphenyl, 9,4 g (0,18 mol) KOH und eine Spatelspitze KJ wurden in 640 ml Ethanol gelöst. Die Lösung wurde bis zum Sieden erhitzt und dann bei fortwährendem Sieden mit einer Lösung von 42,9 g (0,14 mol) 11-Bromundecansäureisopropylester in 60 ml Ethanol schnell versetzt. Dabei entstand sofort eine milchige Trübung, die mit der Zeit noch intensiver wurde. Nach 64 Stunden wurde der ausgefallene weiße Niederschlag abfiltriert, portionsweise mit 100 ml heißer 10 %iger KOH-Lösung und bis zur Neutralreaktion des Filtrates mit H₂O gewaschen. Nach dem Trocknen erhielt man 25,8 g (73 % der theoretischen Ausbeute) einer weißen pulverartigen Substanz.
Identifizierung: IR- und NMR-Spektrum

### Beispiel 3 Herstellung von Verbindung (2)

22,5 g (35 mmol) Verbindung (1) wurde in 300 ml Dioxan suspendiert. Das Reaktionsgemisch wurde zum Sieden erhitzt und dann tropfenweise mit 10 ml konz. HCl versetzt, wobei eine klare Lösung entstand. Danach wurde das Reaktionsgemisch über Nacht unter Rückfluß erhitzt, wobei sich zwei nicht mischbare Phasen bildeten. Beim Abkühlen des Reaktionsgemisches fiel ein weißer Niederschlag in der oberen organischen Phase aus. Der Niederschlag wurde durch Filtration isoliert und mit H₂O säurefrei gewaschen. Nach Umkristallisation aus Ethanol/Dioxan (2/1) erhielt man 18,0 g (92 % der theoretischen Ausbeute) einer weißen pulverartigen Substanz.
Schmelzpunkt: 170° bis 171°C
Identifizierung:
1.

| | | | | |
|---|---|---|---|---|
| Elementaranalyse: | gef. | C 73,76 % | H 9,00 % | O 17,27 % |
| | ber. | C 73,61 % | H 9,08 % | O 19,31 % |

2. IR- und NMR-Spektrum.

### Beispiel 4 Herstellung von Verbindung (3) und (4)

In einem 100 ml-Dreihalskolben, der mit einem Rückflußkühler, Tropftrichter und Gaseinleitungshahn ausgerüstet war, wurden 4 g (7,2 mmol) (2) gegeben. Danach wurden 10 ml Thionylchlorid unter gutem Rühren innerhalb von 10 Minuten zugetropft. Das Reaktionsgemisch wurde 2 Stunden bei 110°C unter Rückfluß erhitzt, wobei eine braune klare Lösung entstand. Nach Beendigung der Reaktion wurde das überschüssige Thionylchlorid unter schwachem Wasserstrahlvakuum abgezogen und dann das Reaktionsgefäß mit Argon belüftet. Die entstandene Verbindung (3) wurde zweimal mit je 25 ml getrocknetem Dioxan verdünnt; das Lösungsmittel wurde jeweils unter normalem Druck abdestilliert.

Danach wurde (3) erneut in 25 ml getrocknetem Dioxan gelöst und das Gemisch mit einem Eisbad auf etwa 10° bis 15°C gebracht, wobei (3) in Lösung blieb. Nach der Zugabe von 1,8 g (18 mmol) Triethylamin wurden 1,6 g (15,5 mmol) 3-Dimethylamino-1-propylamin in 5 ml Dioxan unter gutem Rühren langsam ins Reaktionsgemisch eingetropft, wobei sich sofort ein gelber Niederschlag ausbildete. Anschließend wurde das Reaktionsgemisch bei Raumtemperatur 40 Stunden lang unter Argonatmosphäre gerührt und dann etwa 10 Minuten unter Rückfluß erhitzt. Man ließ auf Raumtemperatur erkalten und kühlte anschließend weiter mit einem Eisbad. Der dabei ausgefallene Niederschlag wurde durch Filtration isoliert und mit 100 ml kaltem Aceton mehrmals gewaschen. Nach zwei Umkristallisationen aus Dioxan/Aceton erhielt man 2,6 g (50 % der theoretischen Ausbeute) der schwach gelblich gefärbten Verbindung (4).
Identifizierung: IR- und NMR-Spektrum.

### Beispiel 5 Herstellung von Verbindung (5)

2,0 g (28 mmol) (4) wurden in 100 ml Dimethylformamid (DMF) suspendiert; 1,8 g (12 mmol) Methyliodid wurden zu dem Gemisch gegeben, wobei (4) in wenigen Minuten gelöst wurde. Das Reaktionsgemisch wurde unter Lichtausschluß und Argonatmosphäre über Nacht gerührt. Nach Beendigung der Reaktion wurde der Rückstand durch Filtration abgetrennt. Anschließend wurde das gelblich gefärbte Produkt zweimal durch Ausfällen mit CHCl₃/Ether (1/9) isoliert, portionsweise mit 100 ml CHCl₃/Ether (1/9) und anschließend mit wenig Ether gewaschen. Nach einer Umkristallisation aus Ethanol erhielt man 2,5 g (89 % der theoretischen Ausbeute) einer gelblich gefärbten Substanz.
Identifizierung: NMR-Spektrum.

### Beispiel 6 Herstellung von Verbindung (6)

In einem 500 ml-Dreihalskolben wurden 7,5 g (40 mmol) 4,4'-Dihydroxybiphenyl, 9,9 g (177 mmol) KOH, eine Spatelspitze KJ und 100 ml Ethanol/H₂O (1/1) vorgelegt und erhitzt. In die siedende Reaktionsmischung tropfte man innerhalb von 20 Minuten unter heftigem Rühren 24,8 g (99 mmol) Bromundecanol zu, das in 200 ml Ethanol/H₂O (3/1) gelöst war. Danach wurde das Gemisch zwei Tage unter Rückfluß erhitzt, wobei sich ein dicker brauner Niederschlag bildete. Der Niederschlag wurde mit Hilfe einer Ultrazentrifuge isoliert und aus CHCl₃/Ethanol (1/2,5) umkristallisiert. Man erhielt 12,0 g (57 % der theoretischen Ausbeute) farblose silberglänzende schuppenartige Kristalle.
Identifizierung:
1.

| | | | | |
|---|---|---|---|---|
| Elementaranalyse: | gef. | C 77,42 % H | 10,29 % | O 12,29 % |
| | ber. | C 77,52 % H | 10,33 % | O 12,15 % |

2. IR- und NMR-Spektrum.

### Beispiel 7 Herstellung von Verbindung (7)

2,0 g (3,8 mmol) (6) wurden in frisch destilliertem DMF unter Stickstoffatmosphäre suspendiert. Dazu wurden 7,8 g (37,8 mmol) Dicyclohexylcarbodiimid in 5 ml DMF gegeben. Danach wurden 0,8 g (8,4 mmol) Schwefelsäure in 2 ml DMF langsam ins Reaktionsgemisch eingetropft; die Temperatur wurde hierbei durch Eiskühlung unterhalb von 25°C gehalten. Das Gemisch wurde bei Raumtemperatur unter Stickstoffatmosphäre und Lichtausschluß 2 Tage gerührt, wobei sich ein weißer Niederschlag bildete. Nach Beendigung der Reaktion wurden 0,7 ml H₂O unter Eisbadkühlung und heftigem Rühren ins Gemisch gegeben. Danach wurde der Niederschlag durch Filtration abgetrennt. Anschließend wurde das Filtrat, welches das Produkt enthielt, mit 10 %iger KOH-Lösung auf pH 8,5 gebracht. Das Lösungsmittel wurde abdestilliert und der Rückstand über 500 ml Kieselgel mit warmem DMF als Laufmittel chromatographiert. Man erhielt 1,2 g (45 % der theoretischen Ausbeute) einer weißen pulverartigen Substanz.
Identifizierung: NMR-Spektrum.

### Beispiel 8 Die Silanisierung des Trägers

Als Träger wurde Quarzglas bzw. Siliciumwafer verwendet. Der Wafer wurde 1 Minute lang mit H₂O im Ultraschallbad behandelt und mit N₂-Gas sorgfältig getrocknet, wobei die Oberflächen staubfrei gereinigt wurde. Dann wurde der Wafer zur Vorreinigung in Caro'sche Säure (konz. H₂SO₄/H₂O₂ = 7/3) gebracht und darin bei 80°C 1 Stunde lang im Ultraschallbad behandelt. Nach der Abkühlung auf Raumtemperatur wurde der Wafer drei Mal jeweils 60 Sekunden in H₂O im Ultraschallbad behandelt und mit H₂O säurefrei gewaschen. Anschließend wurde der Wafer in H₂O/H₂O₂/NH₃ (5:1:1)-Lösung gebracht und darin 5 Minuten lang bei 80°C behandelt. Danach wurde der Wafer in H₂O gebracht und sorgfältig salzfrei gewaschen. Schließlich wurde der Wafer vor der Silanisierungsreaktion zur Entfernung von Wasserspuren jeweils 2 Minuten lang in Methanol, Methanol/Toluol und Toluol behandelt. Der so erhaltene Wafer wurde in 5 %iger 3-Aminopropyldimethylethoxysilan-Lösung in Toluol unter N₂-Atmosphäre gegeben. Die Silanisierungsreaktion wurde unter N₂-Atmosphäre 15 Stunden durchgeführt. Nach Beendigung der Reaktion wurde der Wafer zunächst zweimal jeweils 30 Minuten lang mit Toluol unter N₂-Atmosphäre behandelt. Schließlich wurde der Wafer jeweils 1 Minute lang mit Toluol, Toluol/Dimethylsulfoxid (DMSO) und DMSO im Ultraschallbad behandelt. Man erhielt eine homogene hydrophobe Oberfläche.

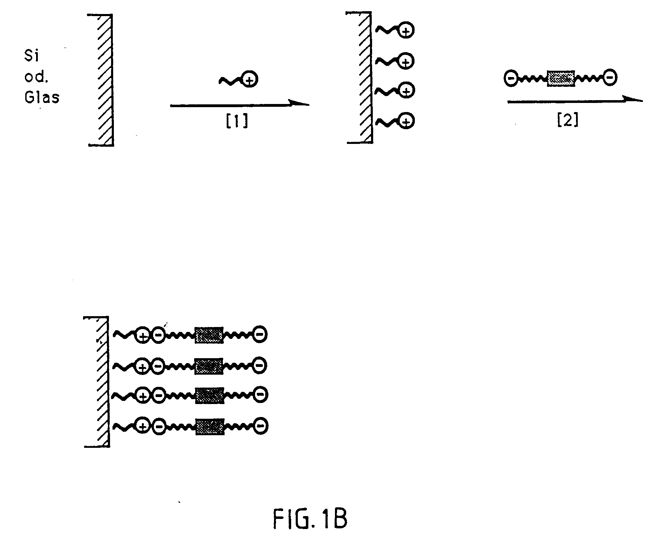

### Beispiel 9 Herstellung eines Trägers mit einer monomolekularen Zwischenschicht nach Figur 1B

Der Quarzglas- bzw. Si-Wafer wurde gemäß Beispiel 8 behandelt. Dieser Wafer, der nunmehr ionisierbare Aminogruppen auf der Oberfläche enthielt, wurde 20 Minuten lang mit einer Lösung aus 4 bis 5 mg (5), 0,3 ml 0,1 N HCl, 1,7 ml H₂O und 8 ml DMSO bei 0°C behandelt, wobei die negativ geladenen Anionen (5) in der Lösung an der positiv geladenen Oberfläche des Wafers zur Salzbildung vom Typ des Ammoniumsulfats adsorbiert wurden. Anschließend wurde der Wafer zunächst in eiskaltem H₂O und zweimal in H₂O bei Raumtemperatur jeweils für 20 Sekunden behandelt. Dieser Wafer mit einer monomolekularen Zwischenschicht wurde zur weiteren Herstellung von Multischichtsystemen bereitgestellt.

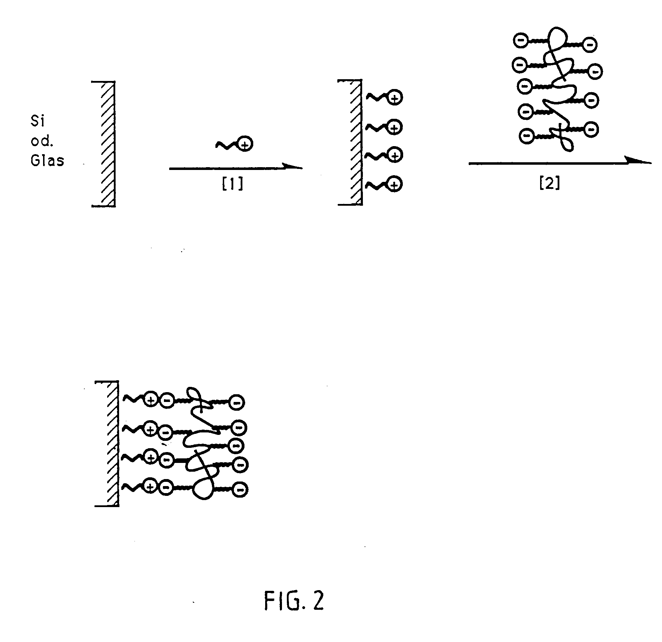

### Beispiel 10 Herstellung eines Trägers mit einer polymeren Zwischenschicht nach Figur 2

Der Quarzglas- bzw. Si-Wafer wurde hierzu gemäß Beispiel 8 behandelt.

Dieser Wafer, der nunmehr ionisierbare Aminogruppen auf der Oberfläche enthielt, wurde 20 Minuten lang mit einer Lösung aus 20 mg Polystyrol-polysulfonsäure-Na-salz (9), 0,3 ml 0,1 N HCl und 9,7 ml H₂O bei Raumtemperatur behandelt, wobei die negativ geladenen Anionen (9) in der Lösung an der positiv geladenen Oberfläche des Wafers zur Salzbildung vom Typ des Ammoniumsulfats adsorbiert wurden. Dieser Wafer mit polymerer Zwischenschicht wurde zur weiteren Herstellung von Multischichtsystemen bereitgestellt.

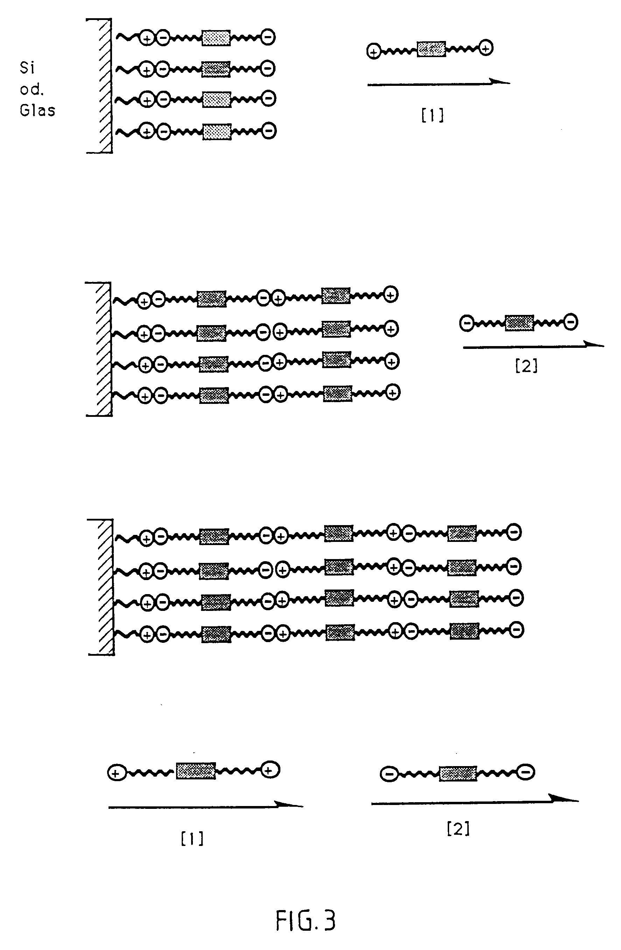

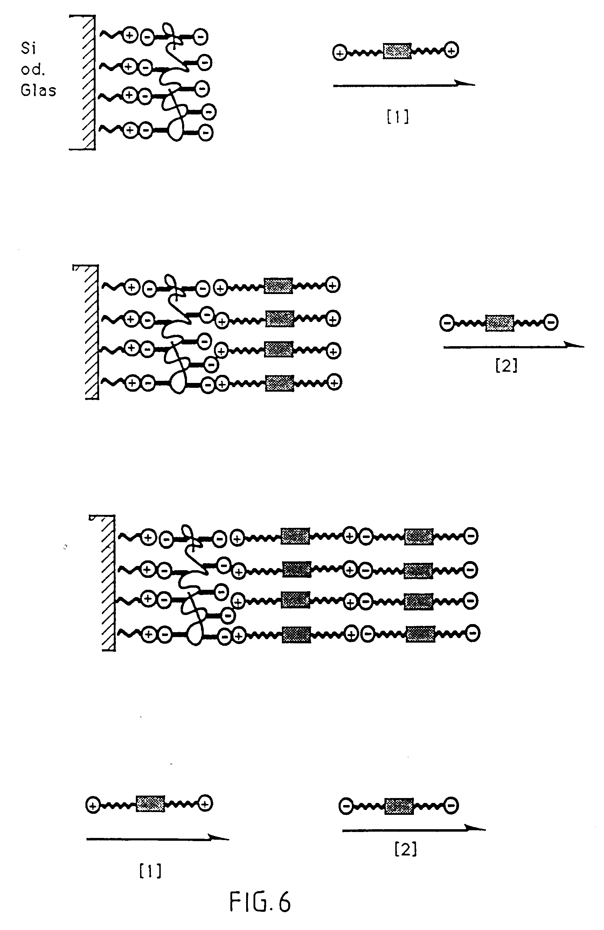

### Beispiel 11: Herstellung einer physisorbierten monomolekularen Multischicht auf der monomolekularen und polymeren Zwischenschicht nach Figur 3 und Figur 6

Es wurden die Träger, die gemäß Beispiel 9 und Beispiel 10 hergestellt wurden, nämlich die Träger mit der monomolekularen bzw. polymeren Zwischenschicht, benutzt.

Der Wafer wurde 20 Minuten lang mit einer Lösung aus 10 mg (7) in 10 ml H₂O bei Raumtemperatur behandelt. Danach folgten drei Spülgänge jeweils 20 sec. lang in H₂O bei Raumtemperatur. Anschließend wurde dieser Wafer 20 Minuten lang mit einer Lösung aus 4 bis 5 mg (5), 2 ml H₂O und 8 ml DMSO bei Raumtemperatur behandelt. Danach wurde der Wafer zunächst in eiskaltem H₂O und zweimal in H₂O bei Raumtemperatur jeweils für 20 sec. behandelt.

Für den Aufbau der Multischicht wurden diese Adsorptionsvorgänge abwechselnd mit (5) bzw. mit (7) wiederholt.

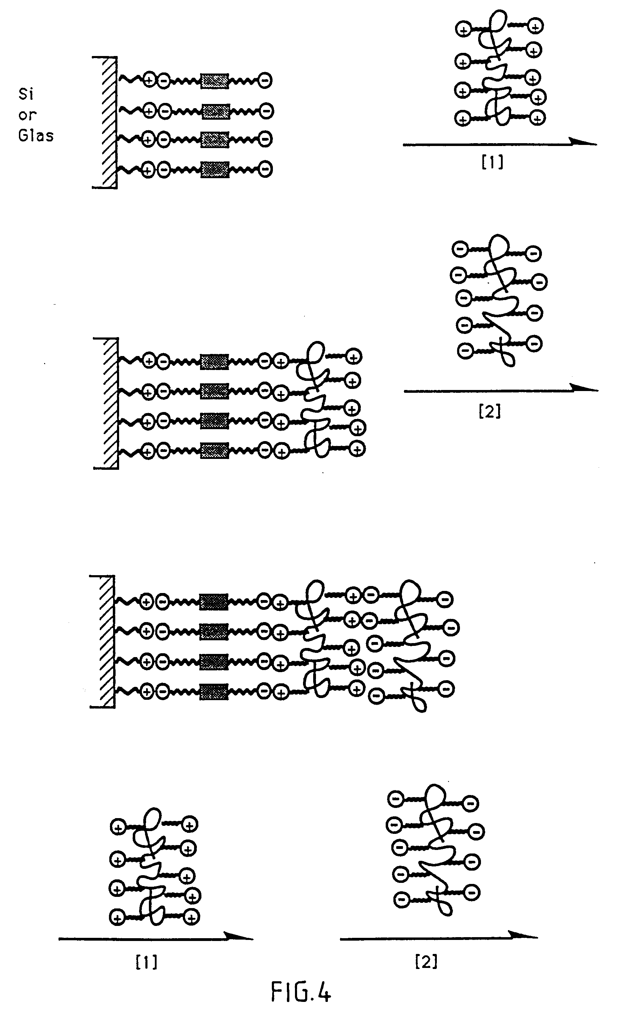

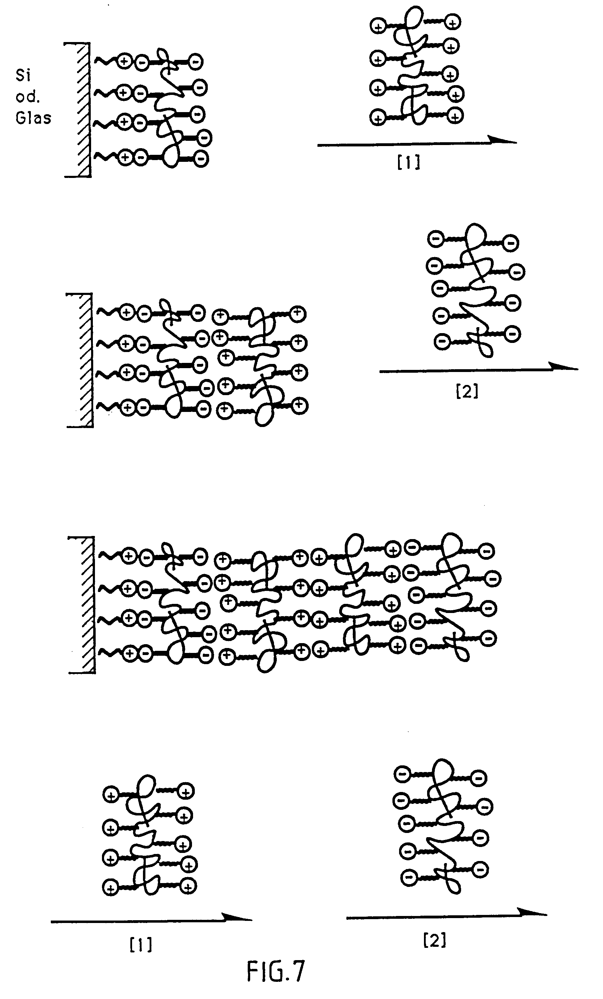

### Beispiel 12: Herstellung einer physisorbierten polymeren Multischicht auf der monomolekularen und polymeren Zwischenschicht nach Figur 4 und Figur 7

Der Träger wurde vorgereinigt und silanisiert, wie es im Beispiel 8 ausführlich beschrieben worden ist. Danach wurden die Träger zur stabilen geladenen Oberfläche gemäß Beispiel 9 und Beispiel 10 behandelt. Der Wafer wurde zunächst in eine Lösung aus 30 mg des oben beschriebenen polymeren Ammonium-Salzes (8) und 10 ml H₂O gegeben und darin 20 Minuten lang bei Raumtemperatur behandelt. Anschließend wurde der Wafer dreimal jeweils 20 Sekunden lang in 10 ml H₂O bei Raumtemperatur gewaschen.

Danach wurde der Wafer in eine Lösung aus 30 mg des beschriebenen Polystyrolsulfonats (9) und 10 ml H₂O gegeben und darin 20 Minuten lang bei Raumtemperatur behandelt. Anschließend wurde der Wafer wiederum jeweils 20 Sekunden lang dreimal in 10 ml H₂O bei Raumtemperatur behandelt. Zum Aufbau der polymeren Multischicht wurde dieses Verfahren in der dem Beispiel 11 entsprechenden Weise fortgesetzt.

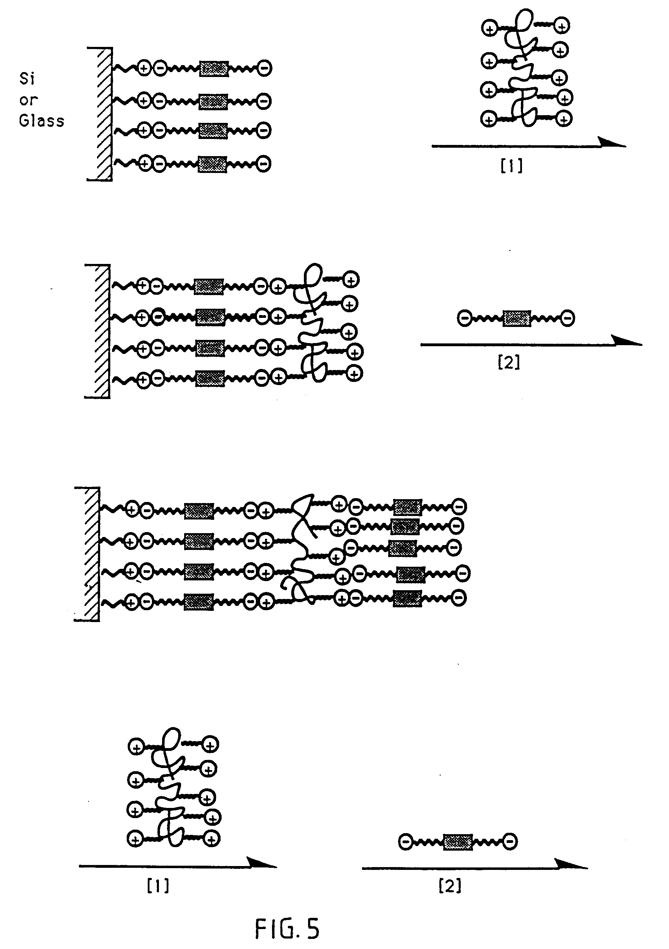

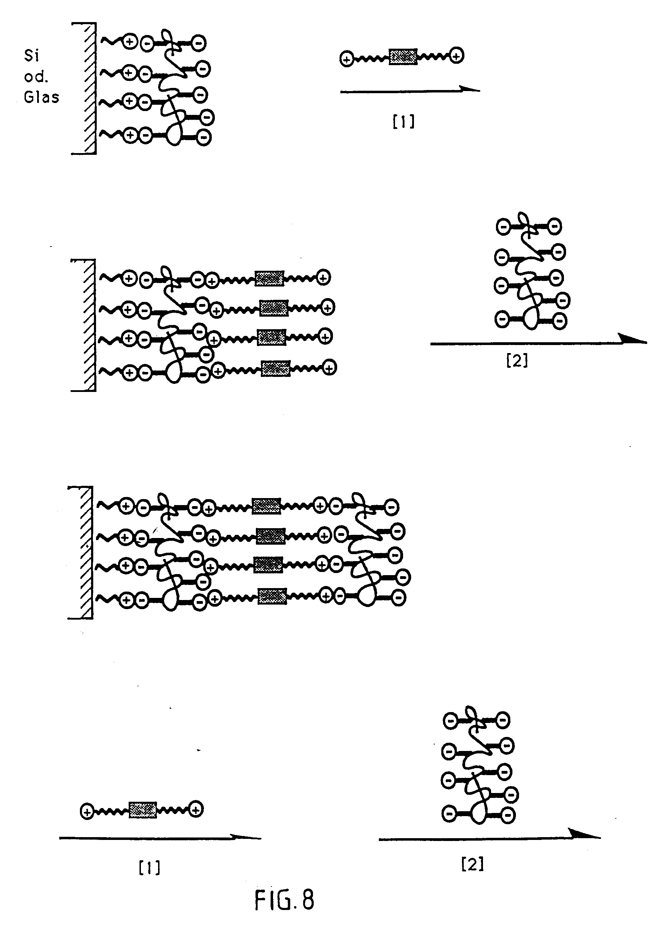

### Beispiel 13: Herstellung einer alternierenden Multischicht aus monomolekularem Di-anion und dem im obigen Schema beschriebenen polymeren Ammoniumsalz auf der monomolekularen und polymeren Zwischenschicht nach Figur 5 und Figur 8

Der Träger wurde vorgereinigt und silanisiert, wie es im Beispiel 8 ausführlich beschrieben worden ist. Danach wurden die Träger zur stabilen geladenen Oberfläche gemäß Beispiel 9 und Beispiel 10 behandelt.

Der Wafer wurde zunächst in eine Lösung aus 30 mg des im obigen Formelschema beschriebenen polymeren Ammoniumsalzes (8) und 10 ml H₂O gegeben und darin 20 Minuten lang bei Raumtemperatur behandelt. Anschließend wurde der Wafer dreimal jeweils 20 Sekunden lang in 10 ml H₂O bei Raumtemperatur gewaschen. Danach wurde der Wafer in eine Lösung aus 4 bis 5 mg (5), 2 ml H₂O und 8 ml DMSO gegeben und darin 20 Minuten lang bei Raumtemperatur behandelt, Anschließend wurde der Wafer zunächst in eiskaltem H₂O und zweimal in H₂O bei Raumtemperatur jeweils für 20 Sekunden lang behandelt.

Zum Aufbau der alternierenden Multischicht wurde dieses Verfahren in der dem Beispiel 11 und dem Beispiel 12 entsprechenden Weise fortgesetzt.

### Beispiel 14 Herstellung von ε-biotinyliertem Poly-l-lysin (Verbindung 8)

Die Verbindung 8 wurde durch Reaktion von Poly-l-lysin (SERVA, Mn = 50.000-100.000) mit dem aktivierten Biotinaktivester (Biotin-N-hydroxysuccinimid ≡ BNHS) hergestellt. 50 mg (0,5 mmol) Poly-l-lysin und 30 mg (0,5 mmol) Triethylamin wurden in einem 100 ml-Kolben vorgelegt und in 30 ml Methanol gelöst. Anschließend wurden 40 mg (0.024 mmol) BNHS, gelöst in 10 ml CHCl₃/Isopropanol (1:1), langsam in das Reaktionsgemisch getropft, für eine Stunde unter Rühren auf Rückfluß erhitzt und danach bei Raumtemperatur über Nacht gerührt. Der dabei entstandene gelbliche Niederschlag wurde durch Filtration isoliert. Er wurdein 30 ml Methanol suspendiert, 20 Minuten unter Rückfluß gerührt, und wiederum auf Raumtemperatur abgekühlt. Der Feststoff wurde erneut durch Filtration abgetrennt und portionsweise dreimal jeweils mit 20 ml Methanol gewaschen, wiederum in 10 ml CHCl₃/Isopropanol (1:1) suspendiert, nochmals 20 Minuten unter Rückfluß gerührt und wieder auf Raumtemperatur abgekühlt. Nach Filtration wurde der Feststoff portionsweise dreimal jeweils mit 20 ml CHCl₃/Isopropanol (1:1) gewaschen. Der so isolierte Rückstand wurde unter Ölpumpenvakuum getrocknet, in wenig destilliertem Wasser gelöst und gelpermeationschromatographisch von niedermolekularen Nebenprodukten befreit. Das reine farblose Copolymer wurde durch Gefriertrocknung aus einer wäßrigen Lösung erhalten.

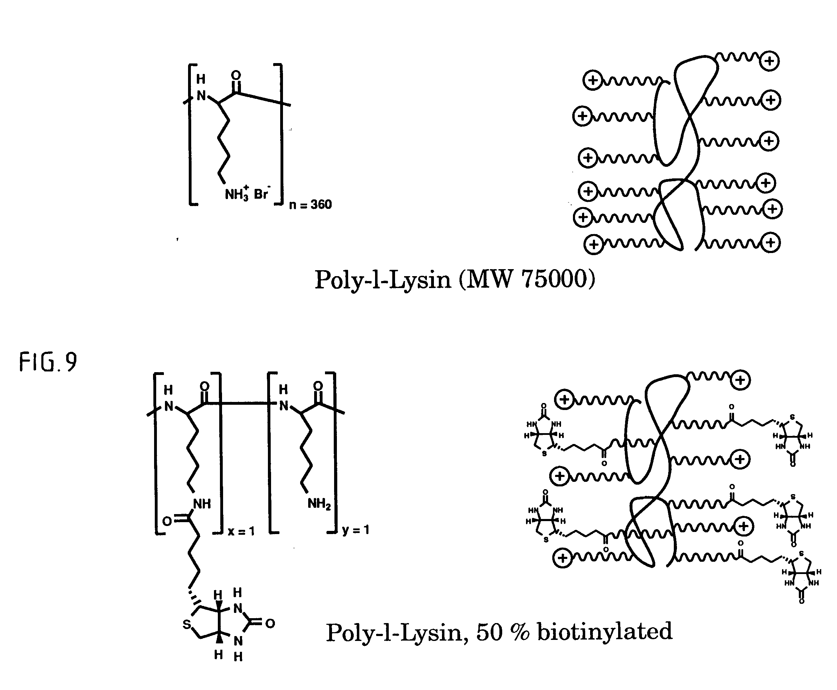

Die Ausbeute lag bei 25 % der Theorie. Das biotinylierte Poly-l-lysin wurde durch IR- und NMR-Spektroskopie charakterisiert. Laut ¹H-NMR ist die Copolymerenzusammensetzung (l-Lysin/l-Lysin-ε-aminobiotinamid) 1:1 (Formeldarstellungen in Fig. 9).

### Beispiel 15: Herstellung einer physisorbierten Multischicht mit einer Deckschicht aus Poly-l-lysin

Der Träger wurde vorgereinigt und silanisiert, wie es im Beispiel 8 ausführlich beschrieben worden ist. Danach wurde der Träger gemäß Beispiel 9 durch Adsorption des niedermolekularen Dianions mit einer negativen Oberfläche versehen.

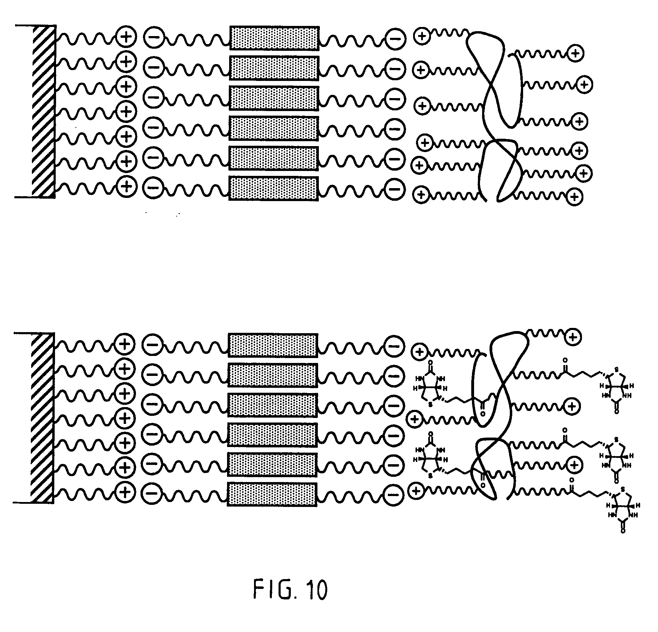

Der Wafer wurde 20 Minuten bei Raumtemperatur mit einer Lösung von 2 mg Poly-l-lysin in einer Mischung aus 2,8 ml H₂O und 0,2 ml 0,1 N HCl behandelt. Anschließend wurde der Wafer dreimal jeweils eine Minute lang in 10 ml H₂O bei Raumtemperatur gewaschen (Grafische Darstellung in Fig. 10, oberes Bild).

### Beispiel 16: Herstellung einer physisorbierten Multischicht mit einer Deckschicht aus biotinyliertem Poly-l-lysin (Verbindung 8)

Der Träger wurde vorgereinigt und silanisiert, wie es im Beispiel 8 ausführlich beschrieben woren ist. Danach wurde der Träger gemäß Beispiel 9 durch Adsorption des niedermolekularen Dianions mit einer negativen Oberfläche versehen.

Der Wafer wurde 20 Minuten bei Raumtemperatur mit einer Lösung von 2,3 mg des in Beispiel 14 hergestellten biotinyliertem Poly-l-lysin in einer Mischung aus 2,8 ml H₂O und 0,2 ml 0,1 N HCl behandelt. Anschließend wurde der Wafer dreimal jeweils eine Minute lang in 10 ml H₂O bei Raumtemperatur gewaschen (Grafische Darstellung in Fig. 10, unteres Bild).

### Beispiel 17: Biospezifische Erkennungsreaktion einer biotinylierten Trägeroberfläche im Vergleich zu einer nicht biotinylierten Trägeroberfläche mittels fluoreszenzmarkiertem Streptavidin

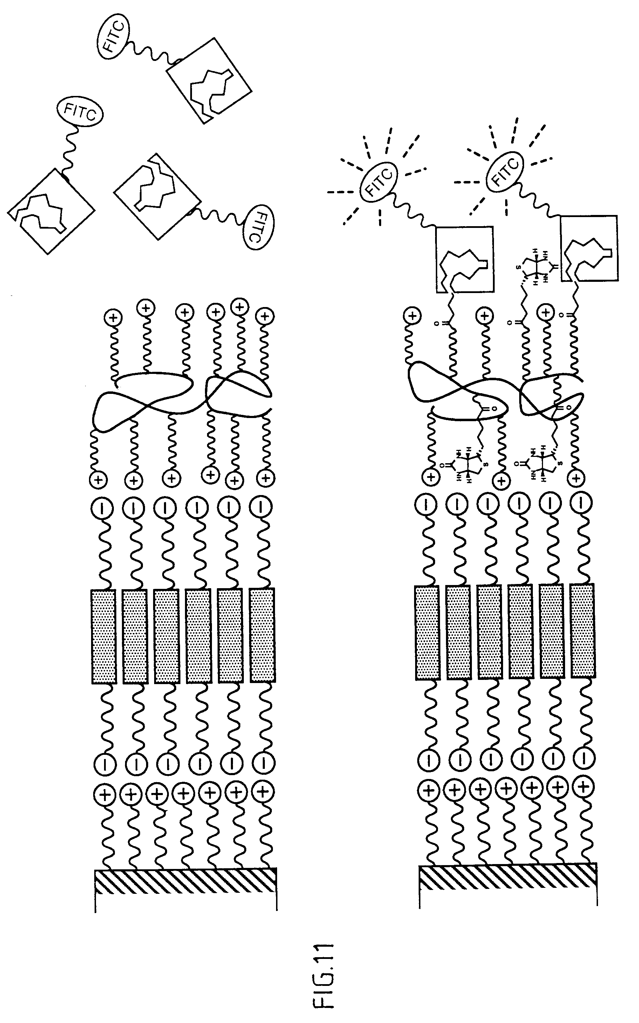

Die in Beispiel 15 und Beispiel 16 hergestellten Multischichtsysteme wurden gleichzeitig in eine Lösung aus 0,02 mg fluoreszeinisothiocycanatmarkiertem Streptavidin in 4.0 ml 0,15 m NaCl Lösung bei Raumtemperatur getaucht. Nach 20 Minuten wurden die beiden Träger jeweils dreimal eine Minute lang in 10 ml H₂O bei Raumtemperatur gewaschen und anschließend fluoreszenzmikroskopisch und spektroskopisch untersucht. Der in Beispiel 15 hergestellte Träger mit einer Oberfläche aus reinem Poly-l-lysin zeigte im Fluoreszenzmikroskop eine sehr geringe Fluoreszenz, die von wenigen adsorbierten fluoreszierenden Partikeln stammte. Der in Beispiel 16 hergestellte Träger mit einer Oberfläche aus biotinyliertem Poly-l-lysin zeigte im Fluoreszenzmikroskop eine gleichmäßig verteilte sehr intensive Fluoreszenz (Grafische Darstellung in Fig. 11). Fluoreszenzspektroskopisch wurde am Träger aus Beispiel 16 eine relative Fluoreszenzintensität am Maximum der Fluoreszenz von 100 Skalenteilen ermittelt. Der Träger aus Beispiel 15 zeigte eine relative Fluoreszenzintensität von 8 Skalenteilen.

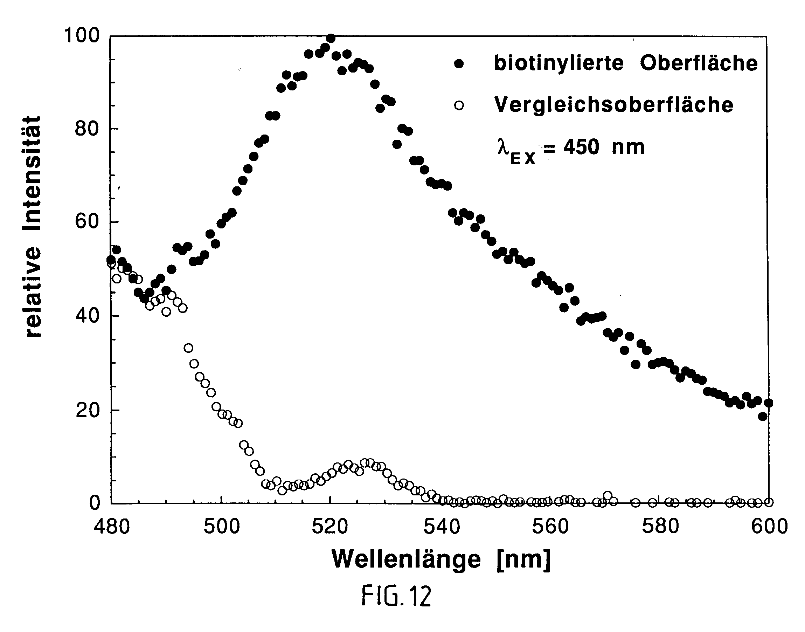

Das Fluoreszenzspektrum für Beispiel 17 ist in Fig. 12 dargestellt.

## Patentansprüche

1. Auf einem Träger angebrachtes Schichtelement, bestehend aus
a) einem modifizierten Träger mit ebenmäßiger Oberfläche, wobei die Modifizierung die flächenweite Anbringung von Ionen oder ionisierbaren Verbindungen gleichsinniger Ladung bedeutet, und
b) einer oder mehrerer Schichten aus organischen Materialien, die in jeder Schicht gleichsinnig geladene Ionen enthalten, wobei die Ionen der ersten Schicht den entgegengesetzten Ladungssinn zur Modifizierung des Trägers aufweisen und bei mehreren Schichten jede weitere wiederum den entgegengesetzten Ladungssinn zur vorangegangenen aufweist dadurch gekennzeichnet, daß die organischen Materialien monomere Stoffe mit zwei ionischen oder ionisierbaren funktionellen Gruppen gleichsinniger Ladung oder Polymere mit einer Vielzahl ionischer oder ionisierbarer funktioneller Gruppen gleichsinniger Ladung (Polyelektrolyte) sind.

2. Verfahren zur Herstellung von auf einem Träger angebrachten Schichtelementen, dadurch gekennzeichnet, daß man
i) einen Träger mit ebenmäßiger Oberfläche so modifiziert, daß er flächenweit Ionen oder ionisierbare Verbindungen gleichsinniger Ladung trägt, und
ii) eine oder mehrere Schichten aus organischen Materialien, die in jeder Schicht gleichsinnig geladene Ionen enthalten, aus einer Lösung solcher organischer Materialien auf den modifizierten Träger aufträgt, wobei das organische Material für die erste Schicht Ionen mit entgegengesetztem Ladungssinn zum Ladungssinn der Ionen der Modifizierung des Trägers aufweist und im Falle von mehreren Schichten abwechselnd weitere Schichten mit Ionen mit dem jeweils entgegengesetzten Ladungssinn zur vorhergehenden in gleicher Weise wie die erste Schicht aufträgt dadurch gekennzeichnet, daß die organischen Materialien monomere Stoffe mit zwei ionischen oder ionisierbaren funktionellen Gruppen gleichsinniger Ladung oder Polymere mit einer Vielzahl ionischer oder ionisierbarer funktioneller Gruppen gleichsinniger Ladung (Polyelektrolyte) sind.

3. Schichtelemente nach Anspruch 1, bei denen die modifizierten Träger ausgewählt werden aus der Gruppe
- der mit einem Thiol einschichtig belegten Metalloberflächen, wobei das Thiol eine weitere ionische oder ionisierbare funktionelle Gruppe trägt,
- der mit einem Silan behandelten, Silicium enthaltenden Träger, wobei das Silan eine ionische oder ionisierbare funktionelle Gruppe trägt, und
- der Polymeren, die durch polymeranaloge Umsetzung oberflächlich ionische oder ionisierbare funktionelle Gruppen tragen.

4. Schichtelemente nach Anspruch 1, in denen die zwei funktionellen Gruppen bei monomeren Stoffen bzw. die Vielzahl der funktionellen Gruppen bei Polymeren jeweils identisch sind.

5. Schichtelemente nach Anspruch 1, in denen die monomeren Stoffe solche der Formel
Ion-Z¹-(-Y¹-Z²-)ₘ-X-Z³-Y²-Z⁴-Ion (I)
sind, in der
X -C≡C-C≡C-, 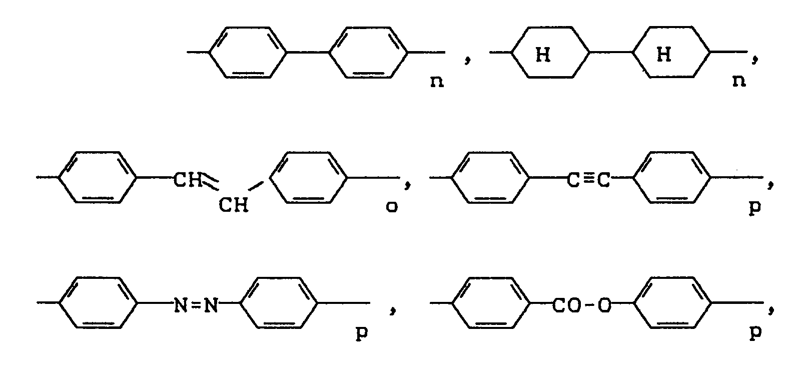 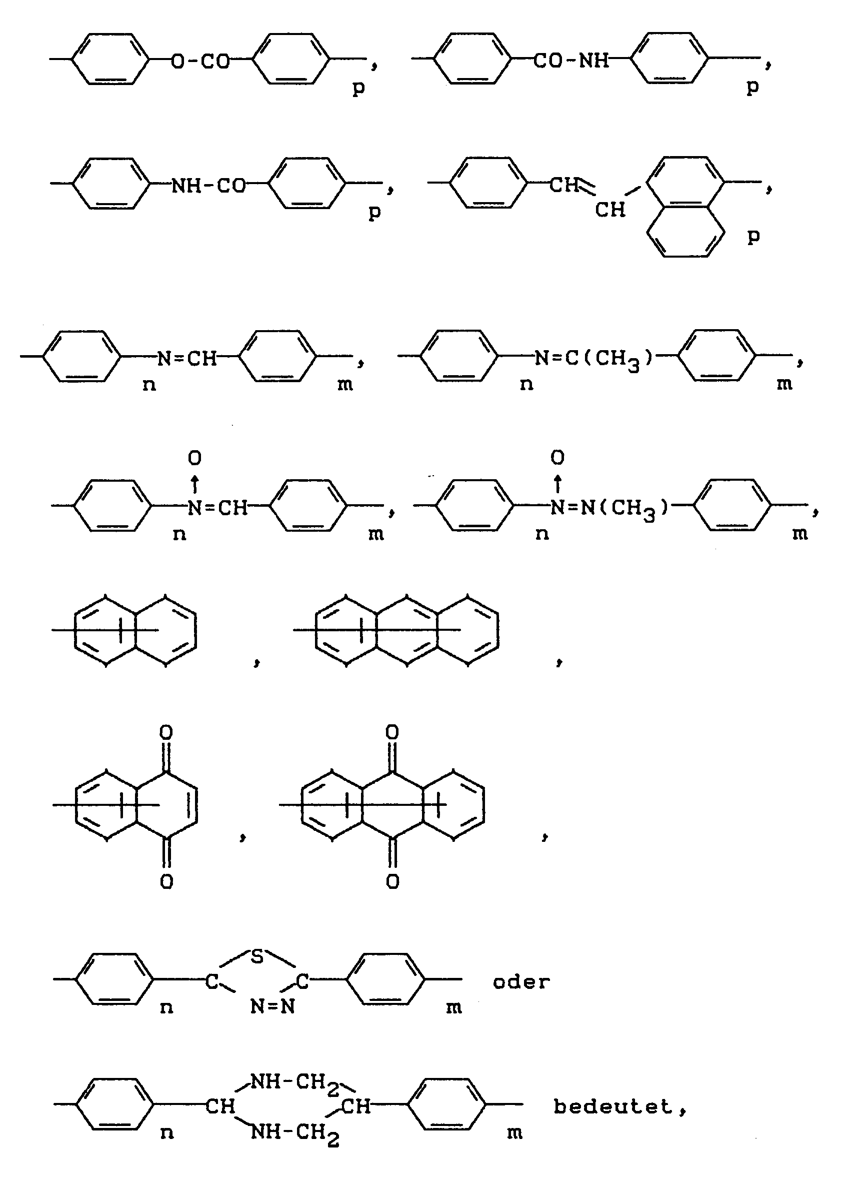 wobei die aromatischen Kerne in diesen Gruppen ein- bis dreifach durch Methyl, Fluor oder Chlor substituiert oder zum Cycloalkan hydriert sein können,
Y¹ und Y² unabhängig voneinander für -(-CH₂-)_{q}-, -(-Si(CH₃)₂-O-)_{q}-, -(-CH=CH-)_{q}- oder -(C≡C-)_{q}- stehen,
wobei in diesen Gruppen die Wasserstoffatome teilweise oder ganz durch Methyl, Fluor oder Chlor substituiert sein können,
Z¹, Z², Z³ und Z⁴ unabhängig voneinander eine Einfachbindung, -O-, -S-, -CO-, -SO-, -SO₂-, -CO-O-, -O-CO-, =N-CO, -CO-N=, -NH- oder -N(C₁-C₄-Alkyl)- darstellen,
Ion für ein Kation, ein Anion oder eine zum Kation oder Anion ionisierbare Gruppe steht,
m 0 oder 1, bevorzugt 1,
n ganzzahlige Werte von 0 bis 7,
o ganzzahlige Werte von 1 bis 3,
p den Wert 1 oder 2 und
q ganzzahlige Werte von 1 bis 20 darstellen.

6. Schichtelemente nach Anspruch 5, dadurch gekennzeichnet, daß X eine der Gruppen 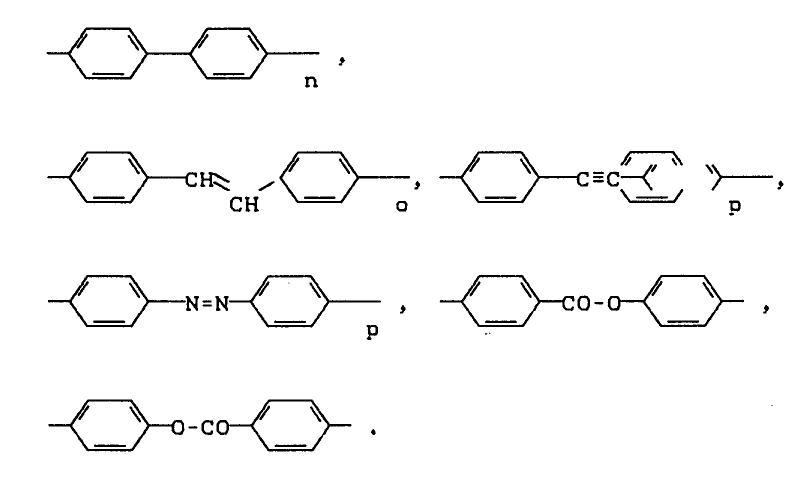 bedeutet.

7. Verfahren nach Anspruch 2, dadurch gekennzeichnet, daß als Lösungsmittel für die Herstellung der funktionelle Gruppen tragenden organischen Materialien Wasser oder ein Gemisch von Wasser mit einem mit Wasser mischbaren, nicht ionischen organischen Lösungsmittel eingesetzt wird.

## Claims

1. Layer element applied to a support, comprising
a) a modified support having an even surface, in which modification means the application of ions or ionisable compounds of the same charge over the entire area, and
b) one or more layers made of organic materials which in each layer contain ions of the same charge, the ions of the first layer having the opposite charge of the modified support and in the case of several layers each further layer having again the opposite charge of the previous layer, characterised in that the organic materials are monomeric substances having two ionic or ionisable functional groups of the same charge or polymers having a multiplicity of ionic or ionisable functional groups of the same charge (polyelectrolytes).

2. Process for the preparation of layer elements applied to a support, characterised in that
i) a support having a flat surface is modified such that it carries ions or ionisable compounds of the same charge over the entire area, and
ii) one or more layers made of organic materials, which in each layer contain ions of the same charge, are applied from a solution of such organic materials to the modified support, the organic material for the first layer having ions of the opposite charge relative to the charge of the ions of the modified support and, in the case of multiple layers, alternately further layers containing ions of the opposite charge in each case relative to the previous one are applied in the same manner as the first layer, characterised in that the organic materials are monomeric substances having two ionic or ionisable functional groups of the same charge or polymers having a multiplicity of ionic or ionisable functional groups of the same charge (polyelectrolytes).

3. Layer elements according to Claim 1, in which the modified supports are selected from the group comprising
- the metal surfaces covered with a single layer of thiol, in which the thiol carries a further ionic or ionisable functional group,
- the support treated with a silane and containing silicon, in which the silane carries an ionic or ionisable functional group, and
- the polymers carrying ionic or ionisable functional groups on the surface as a result of polymer-analogous reaction.

4. Layer elements according to Claim 1, in which the two functional groups in the monomeric substances or the multiplicity of the functional groups in the polymers are in each case identical.

5. Layer elements according to Claim 1, in which the monomeric substances are those of the formula
ion-Z¹-(-Y¹-Z²-)ₘ-X-Z³-Y²-Z⁴-ion (I)
in which
X represents -C≡C-C≡C-, 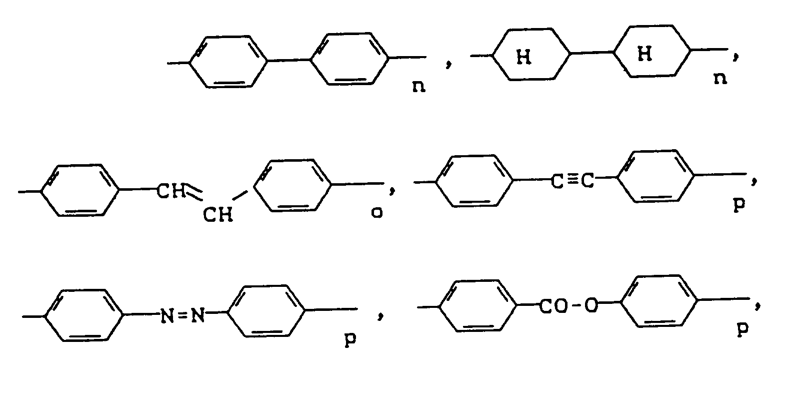 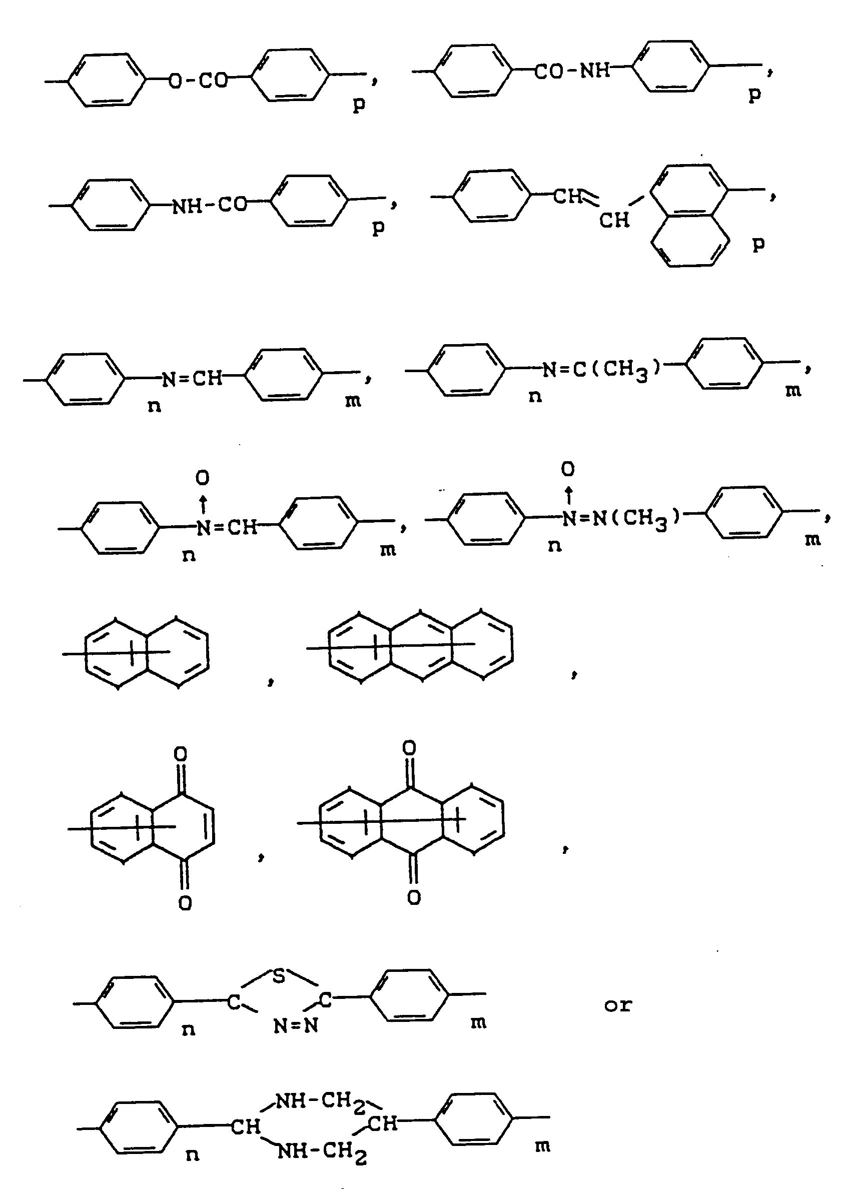 in which the aromatic rings in these groups can be mono- to trisubstituted by methyl, fluorine or chlorine or can be hydrogenated to the cycloalkane,
Y¹ and Y², independently of one another, represent -(-CH₂-)_{q}-, -(-Si(CH₃)₂-O-)_{q}-, -(-CH=CH-)_{q}- or - (C≡C-)_{q}-, it being possible for the hydrogen atoms in these groups to be substituted in part or completely by methyl, fluorine or chlorine,
Z¹, Z², Z³ and Z⁴ , independently of one another, represent a single bond, -O-, -S-, -CO-, -SO-, -SO₂-, -CO-O-, -O-CO-, =N-CO, -CO-N=, -NH- or -N(C₁-C₄-alkyl)-,
ion represents a cation, or an anion or a group which can be ionised to the cation or the anion,
m represents 0 or 1, preferably 1,
n represents integral values from 0 to 7,
o represents integral values from 1 to 3,
p represents the value 1 or 2 and
q represents integral values from 1 to 20.

6. Layer elements according to Claim 5, characterised in that X represents one of the groups

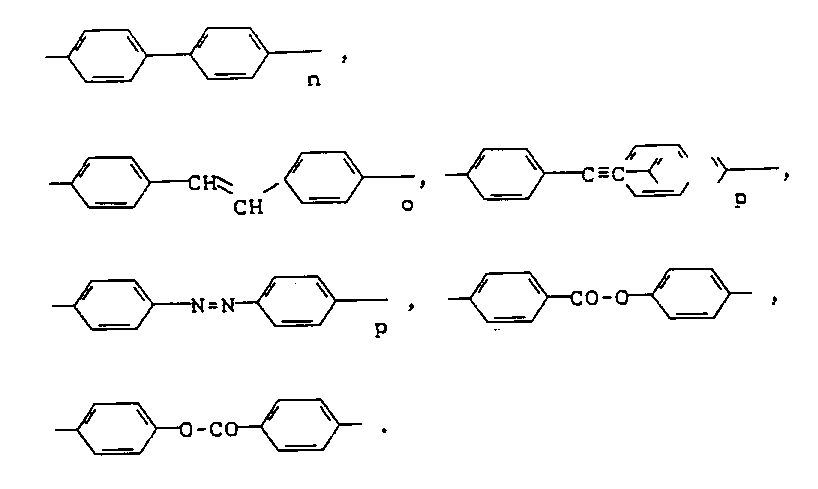

7. Process according to Claim 2, characterised in that the solvent used for the preparation of the organic materials carrying functional groups is water or a mixture of water with a water-miscible, nonionic organic solvent.

## Revendications

1. Eléments ou dépôts formés d'une ou de plusieurs couches (éléments stratifiés) appliqués sur un support et consistant en :
a) un support modifié présentant une surface homogène, la modification signifiant l'application, sur toute la surface, d'ions ou de composés ionisables ayant une charge de même signe, et
b) une ou plusieurs couches de matières organiques, qui contiennent dans chaque couche des ions ayant une charge de même signe, les ions de la première couche présentant le signe contraire de charge pour la modification du support et, dans le cas de plusieurs couches, chaque autre couche présentant le signe de charge contraire à celui de la couche précédente, éléments caractérisés en ce que les matières organiques sont des substances monomères comportant deux groupes fonctionnels ioniques ou ionisables ayant une charge de même signe ou des polymères comportant un grand nombre de groupes fonctionnels ioniques ou ionisables ayant une charge de même signe (des polyélectrolytes).

2. Procédé de préparation d'éléments stratifiés ou de dépôts formés d'une ou de plusieurs couches appliquées sur un support, procédé caractérisé en ce que :
i) on modifie un support, ayant une surface homogène, de façon qu'il porte, sur l'étendue de la surface, des ions ou des composés ioniques ayant une charge de même signe, et
ii) on provoque l'application par dépôt, sur le support modifié, d'une ou plusieurs couches de matières organiques qui contiennent dans chaque couche des ions de charge de même signe, à partir d'une solution de telles matières organiques, la matière organique pour la première couche présentant des ions dont la charge a un signe contraire à celui de la charge des ions de la modification du support et, dans le cas de plusieurs couches, on provoque le dépôt par applications alternées d'autres couches comportant des ions ayant chacune une charge de signe antagoniste à celui de la couche précédente, en opérant de la même façon que pour la première, procédé caractérisé en ce que les matières organiques sont des substances monomères comportant deux groupes fonctionnels ioniques ou ionisables de charge de même signe ou sont des polymères ayant un grand nombre de groupes fonctionnels ioniques ou ionisables dont la charge est de même signe (ce sont des polyélectrolytes).

3. Eléments stratifiés selon la revendication 1, dans lesquels les supports modifiés sont choisis dans le groupe ou ensemble formé par :
- des surfaces métalliques chargées d'une monocouche de thiol, le thiol portant un autre groupe fonctionnel ionique ou ionisable,
- des supports contenant du silicium et traités par un silane, le silane portant des groupes fonctionnels ioniques ou ionisables, et
- des polymères qui, par réaction analogue (à formation) de polymères portent en surface des groupes fonctionnels ioniques ou ionisables.

4. Eléments de couche ou dépôts de couche selon la revendication 1, dans lesquels les deux groupes fonctionnels des substances monomères ou, dans le cas de polymères, le grand nombre des groupes fonctionnels, sont à chaque fois identiques.

5. Eléments stratifiés ou dépôts de couche selon la revendication 1, dans lesquels les substances monomères sont celles de formule :
Ion-Z¹-(-Y¹-Z²-)ₘ-X-Z³-Y²-Z⁴-Ion (I)
dans laquelle
X représente
-C≡C-C≡C-, 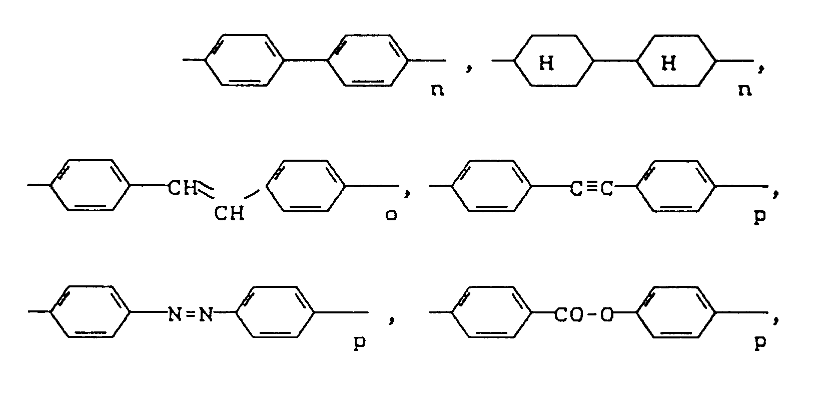 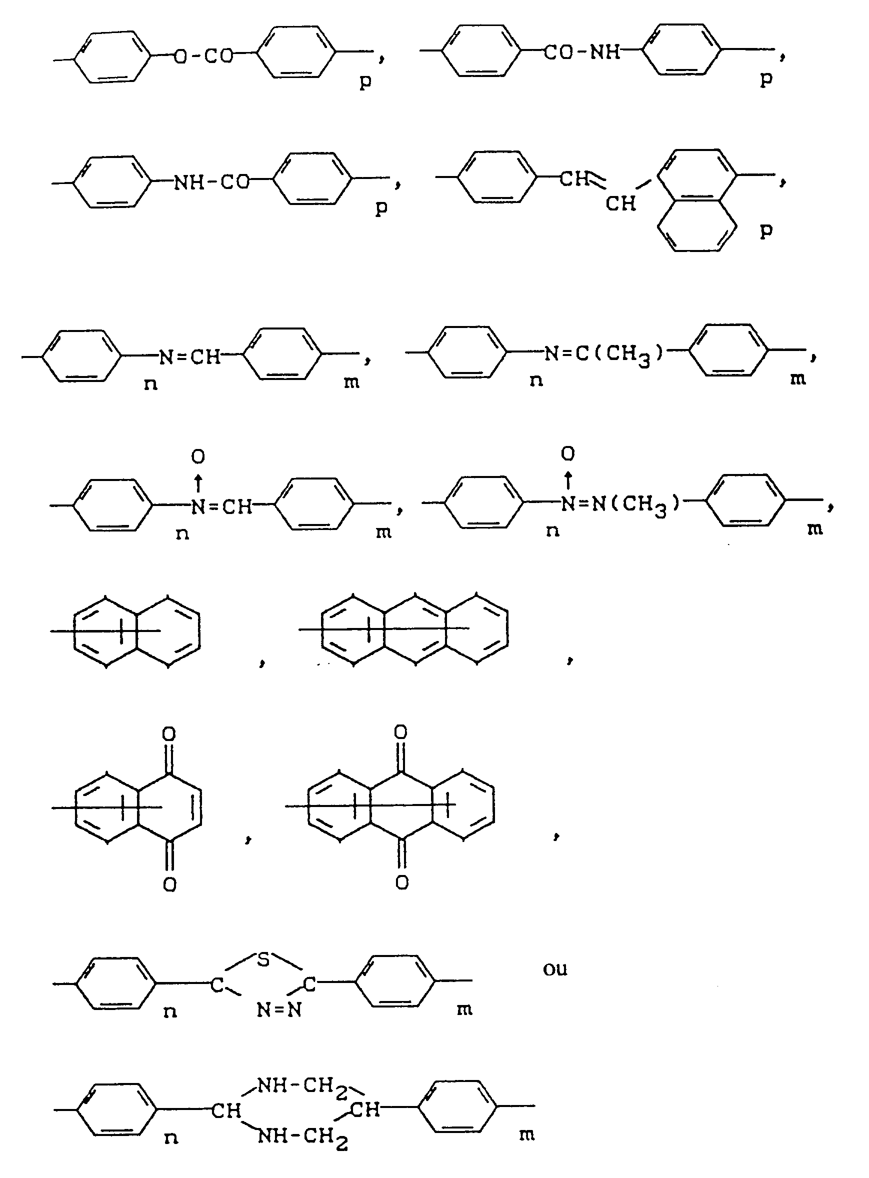 les noyaux aromatiques présents dans ces groupes pouvant être substitués une à trois fois par un groupe méthyle, fluoro ou chloro ou pouvant être hydrogénés en donnant du cycloalcane,
Y¹ et Y² représentent chacun, indépendamment l'un de l'autre, un groupe (̵CH₂)̵_{q}, (̵Si(CH₃)₂-O)̵_{q}, (̵CH=CH)̵_{q} ou (̵C≡C)̵_{q},
et, dans ces groupes, les atomes d'hydrogène pouvant partiellement ou entièrement être remplacés, par substitution, par un groupe méthyle, fluoro ou chloro,
Z¹, Z², Z³ et Z⁴ représentant chacun, indépendamment l'un de l'autre, une liaison simple, -O-, -S-, -CO-, -SO-, -SO₂-, -CO-O-, -O-CO-, =N-CO-, -CO-N=, -NH- ou un groupe -N(alkyle en C₁ à C₄)-.
Ion représente un cation, un anion ou un groupe ionisable en donnant un cation ou un anion,
m vaut 0 ou 1, de préférence 1,
n représente des nombres entiers valant 0 à 7,
o représente des nombres entiers valant 1 à 3,
p vaut 1 ou 2, et
q représente des nombres entiers valant 1 à 20.

6. Eléments stratifiés ou dépôts de couche(s) selon la revendication 5, caractérisés en ce que X représente l'un des groupes :

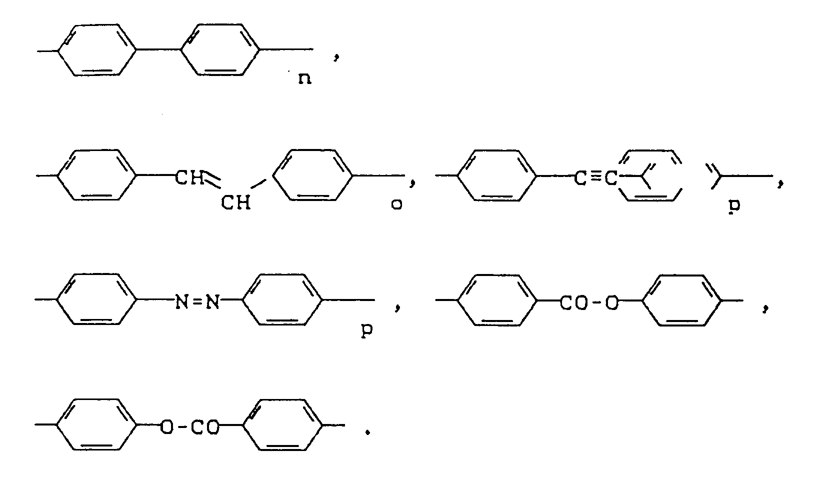

7. Procédé selon la revendication 2, caractérisé en ce que, pour la préparation des matières organiques portant des groupes fonctionnels, on utilise comme solvant de l'eau ou un mélange d'eau avec un solvant organique non ionique, miscible à l'eau.
